(19) Europäisches Patentamt / European Patent Office / Office européen des brevets

(11) **EP 2 195 821 B1**

(12) **EUROPÄISCHE PATENTSCHRIFT**

(45) Veröffentlichungstag und Bekanntmachung des Hinweises auf die Patenterteilung:
**10.07.2013   Patentblatt 2013/28**

(21) Anmeldenummer: **08834787.7**

(22) Anmeldetag: **26.09.2008**

(51) Int Cl.:
*H01J 37/147* (2006.01)    *H01J 37/02* (2006.01)
*H01J 37/14* (2006.01)    *H01J 37/317* (2006.01)
*H01J 37/04* (2006.01)    *H01J 37/30* (2006.01)
*B82Y 10/00* (2011.01)    *B82Y 40/00* (2011.01)

(86) Internationale Anmeldenummer:
**PCT/EP2008/062967**

(87) Internationale Veröffentlichungsnummer:
**WO 2009/043824 (09.04.2009 Gazette 2009/15)**

(54) **VORRICHTUNG ZUR ABLENKUNG ODER EINLENKUNG EINES TEILCHENSTRAHLS**

DEVICE FOR DEFLECTING OR GUIDING IN A PARTICLE BEAM

DISPOSITIF DESTINÉ À DÉVIER OU À FOCALISER UN FAISCEAU DE PARTICULES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **29.09.2007   DE 102007046783**

(43) Veröffentlichungstag der Anmeldung:
**16.06.2010   Patentblatt 2010/24**

(73) Patentinhaber: **Carl Zeiss NTS GmbH**
**73447 Oberkochen (DE)**

(72) Erfinder: **PREIKSZAS, Dirk**
**73447 Oberkochen (DE)**

(74) Vertreter: **Patentanwälte Freischem**
**Salierring 47-53**
**50677 Köln (DE)**

(56) Entgegenhaltungen:
**EP-A- 0 899 771     EP-A- 1 172 837**
**EP-A- 1 760 762     GB-A- 2 339 070**
**US-A- 5 721 432**

• **REIMER L ET AL:**
**"Rasterelektronenmikroskopie", 1 January 1977 (1977-01-01), 19770101, XP002514137,**

**Beschreibung**

Die Erfindung betrifft eine Vorrichtung zur Ablenkung eines Teilchenstrahls aus einer Strahlachse oder zur Einlenkung eines Teilchenstrahls in die Strahlachse. Ferner betrifft die Erfindung ein Teilchenstrahlgerät mit einer derartigen Vorrichtung.

Aus dem Stand der Technik sind Lithographiegeräte bekannt, mit denen Muster und Strukturen mittels einer Belichtung von Materialien (beispielsweise eine Belichtung durch einen Teilchenstrahl) auf Flächen aufgebracht werden können.

Für ein derartiges Lithographiegerät ist aus dem Stand der Technik eine Ablenkvorrichtung für einen Teilchenstrahl bekannt, die im Strahlengang eines als Teilchenstrahlgerät ausgebildeten Lithographiegeräts angeordnet ist. Bei diesem bekannten Teilchenstrahlgerät wird ein Elektronenstrahl von einer Elektronenquelle erzeugt, von Linsen fokussiert und auf ein Objekt geleitet. Im Strahlengang des Elektronenstrahls sind eine Austastblende und eine Ablenkeinheit angeordnet. Diese bekannte Ablenkeinheit ist plattenförmig ausgebildet und kombiniert eine magnetische Ablenkung mit einer elektrostatischen Ablenkung. Der vorgenannte Stand der Technik dient der Ausblendung des Elektronenstrahls, so dass Teile des Objektes bei der Lithographie nicht belichtet werden.

Desweiteren ist es aus dem Stand der Technik bekannt, dass ein Elektronenstrahl mittels einer Austasteinheit, die aus zwei übereinander angeordneten Plattenpaaren und einer dazwischen liegenden Apertur besteht, ausgetastet wird.

Hinsichtlich des oben genannten Standes der Technik wird auf die US 4,434,371 sowie auf die Dissertation des Herrn Dr. Martin Müller, "Abstimmbare Halbleiterlaser und schmalbandige Laserarrays mit verteilter lateraler Rückkopplung", Würzburg 2003, Seiten 30-31 verwiesen.

Die oben genannte Kombination von magnetischen und elektrostatischen Ablenkeinheiten ist allerdings recht kompliziert aufgebaut und bedarf eines höheren Aufwands zur Ansteuerung der elektrostatischen und magnetischen Ablenkeinheit hinsichtlich derer Abstimmung.

Ferner ist es aus dem Stand der Technik bekannt, an einem Teilchenstrahlgerät, das mit einer Kondensorlinse und mit einer Objektivlinse versehen ist, eine Ablenkvorrichtung vorzusehen, die mindestens ein Ablenkplattenpaar oder mindestens ein Ablenkspulenpaar aufweist. Dabei ist die Ablenkvorrichtung zwischen der Kondensorlinse und der Objektivlinse an einer Position an der Strahlachse des Teilchenstrahlgeräts angeordnet. Falls zwei Ablenkplattenpaare vorgesehen sind, so sind diese nach dem Stand der Technik zwischen der Kondensorlinse und der Objektivlinse hintereinander (also in der Anordnung Kondensorlinse - Ablenkplattenpaar - Ablenkplattenpaar - Objektivlinse) entlang der Strahlachse des Teilchenstrahlgeräts angeordnet. Mit diesen bekannten Ablenkvorrichtungen ist eine Auslenkung eines Teilchenstrahls zwar möglich, jedoch ist bei diesem bekannten Stand der Technik ein Auswandern des Teilchenstrahls durchaus wahrscheinlich. Unter einer Auswanderung des Teilchenstrahls versteht man eine Bewegung des Auftreffpunkts des Teilchenstrahls auf der Probe (oder einem anderen Gegenstand) nach einer Auslenkung. Der Teilchenstrahl bleibt nach der Auslenkung somit nicht auf der Stelle stehen oder bleibt nicht in einem sehr eingegrenzten Bereich stehen, sondern bewegt sich und kann somit Bereiche einer Probe treffen, die eigentlich nicht bestrahlt werden sollen. Dieses Auswandern ist besonders von Nachteil, da kleine, sehr nah zueinander angeordnete Strukturen durch dieses Auswandern sehr leicht beschädigt werden. Dieser Nachteil ist insbesondere durch die erforderliche schnelle Ansteuerung der Ablenkplattenpaare bedingt. Aufgrund von Laufzeiten in der Ansteuerelektronik ist es oft nicht möglich, das Ablenkplattenpaar bzw. die Ablenkplattenpaare derart genau und schnell zu steuern, dass eine ausreichend sichere Auslenkung gewährleistet ist. Auch müßte die Anordnung der Ablenkplattenpaare zueinander sehr genau sein, damit ein Teilchenstrahl nach dessen Auslenkung sich nicht mehr ungewollt bewegt. Diese genaue Anordnung wäre nur mit einem sehr hohen Aufwand realisierbar.

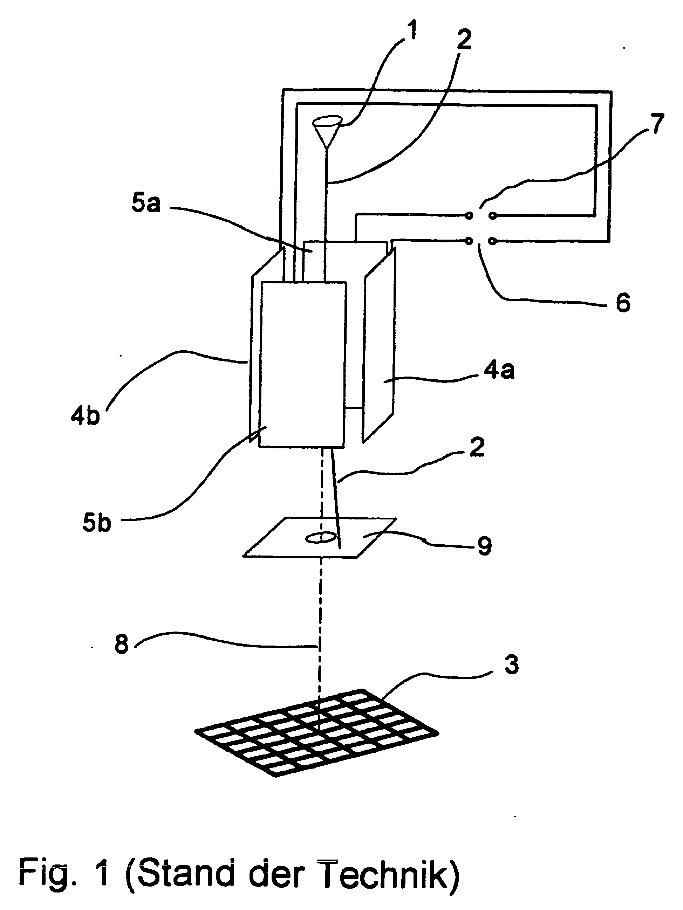

Ein weiterer Stand der Technik wird in Figur 1 wiedergegeben. Figur 1 zeigt ein bekanntes Teilchenstrahlgerät in Form eines Lithographiegeräts mit einer Ablenkvorrichtung zur Auslenkung eines Teilchenstrahls. Das bekannte Teilchenstrahlgerät weist eine Strahlquelle 1 auf, die einen Teilchenstrahl 2 erzeugt. Der Teilchenstrahl 2 wird mit einer geeigneten Linsenanordnung (Kondensor, Objektiv - in Figur 1 nicht dargestellt) entlang einer Strahlachse 8, die der optischen Achse des bekannten Teilchenstrahlgeräts entspricht, auf ein Objekt 3 geleitet. Der Teilchenstrahl 2 ist mittels zweier gekreuzter Ablenkplattenpaare, nämlich ein erstes Ablenkplattenpaar 4a,4b und und ein zweites Ablenkplattenpaar 5a,5b, welche die Ablenkvorrichtung bilden, von der Strahlachse 8 ablenkbar. Das erste Ablenkplattenpaar 4a,4b wird durch eine erste Spannungsversorgungseinheit 6 mit einer Spannung $V_1$ versorgt, während das zweite Ablenkplattenpaar 5a,5b durch eine zweite Spannungsversorgungseinheit 7 mit einer Spannung $V_2$ versorgt wird. Eine bestimmte Ablenkung des Teilchenstrahls 2 von der Strahlachse 8 läßt sich durch geeignete Wahl des Verhältnisses der Spannungen $V_1$ und $V_2$ zueinander einstellen. Dabei wird der Teilchenstrahl 2 derart abgelenkt, dass er auf dem Objekt 3 in eine Richtung gelenkt wird, bei der eine zusätzliche Belichtung nicht stört, bevor der Strahl auf eine Austastblende 9 trifft und somit nicht mehr auf das Objekt 3 geleitet wird. Bei vielen Teilchenstrahlgeräten ist allerdings der vorhandene Bauraum sehr begrenzt, so dass eine gleichzeitige Anordnung von mehreren Ablenkplattenpaaren an einer Stelle in einem Teilchenstrahlgerät oft nicht vorgenommen werden kann. Ferner ist es möglich, dass aufgrund von Signalleufzeiten und Streukapazitäten der Spannungsversorgungen ein bestimmtes Verhältnis der Spannungen $V_1$ und $V_2$ nicht stets gewährleistet ist, so dass eine gewünschte Auslenkung des Teilchenstrahls nicht erzielt wird.

Aue der US 5,721,432 A ist eine Vorrichtung zur Ablenkung eines Teilchenstrahls aus einer Strahlachse bekannt, wobei die Vorrichtung ein erstes Ablenkelement aufweist. Ferner weist die bekannte Vorrichtung eine magnetische Einrichtung zur Bereitstellung eines Magnetfeldes und ein zweites Ablenkelement auf. Das Magnetfeld ist parallel zur Strahlachse ausgerichtet.

Aus der GB 2,338,070 ist ebenfalls eine Vorrichtung zur Ablenkung eines Teilchenstrahls in Form eines Elektronenstrahlgeräts mit zahlreichen Ablenkelementen zur Ablenkung eines Teilchenstrahls aus einer Strahlachse oder zur Einienkung des Teilchenstrahls in die Strahlachse bekannt. Das bekannte Elektronenstrahlgerät weist ein erstes Ablenkelement auf. Vom ersten Ablenkelement aus gesehen sind entlang einer Strahlschse Linsen angeordnet. Ferner sind zweite Ablenkelemente entlang der Strahlachse angeordnet. Ein Magnetfeld ist parallel zur Strahlachse ausgerichtet.

Es ist daher Aufgabe der Erfindung, eine Vorrichtung zur Ablenkung oder Einlenkung eines Teilchenstrehls für ein Teilchenstrahlgerät anzugeben, die einfach aufgebaut ist, wenig Bauraum benötigt und zudem gewährleistet, dass keln Bereich eines Objektes mit einem Teilchenstrahl beaufschlagt wird, der nicht beaufschlagt werden soll.

Erfindungsgemäß wird diese Aufgabe durch eine Vorrichtung mit den Merkmalen des Anspruchs 1 gelöst. Ein erfindungsgemäßes Teilchenstrahlgerät ist durch die Merkmale des Anspruchs 10 charakterisiert.

Erfindungsgemäß ist die Vorrichtung zur Ablenkung eines Teilchenstrahls aus einer Strahlachse oder zur Einlenkung eines Teilchenstrahls in die Strahlachse ausgebildet. Bereits jetzt wird darauf hingewiesen, dass unter Teilchenstrahl ein Strahl mit jeglicher Art von Teilchen (beispielsweise Ionen, Elektronen etc.) verstanden wird. Die erfindungsgemäße Vorrichtung weist mindestens ein erstes Ablenkelement auf. Ferner weist sie eine besondere Reihenfolge der Anordnung der einzelnen Einheiten der Vorrichtung entlang der Strahlachse auf. Vom ersten Ablenkelement aus gesehen sind entlang der Strahlachse mindestens eine magnetische Einrichtung zur Bereitstellung eines Magnetfeldes und mindestens ein zweites Ablenkelement angeordnet. Mit anderen Worten ausgedrückt, weist die erfindungsgemäße Vorrichtung die folgende Anordnung entlang der Strahlachse auf: erstes Ablenkelement - magnetische Einrichtung - zweites Ablenkelement. Ferner ist vorgesehen, dass das Magnetfeld der magnetischen Einrichtung parallel zur Strahlachse ausgerichtet ist (also eine Ausrichtung axial entlang der Strahlachse). Dabei wird hier unter der Strahlachse die Achse verstanden, welche der Teilchenstrahl ohne Beeinflussung durch eine Teilchenoptik oder andere die Bahn verändernde Einheiten einnehmen würde. Darüberhinaus fällt unter die Erfindung auch eine im wesentlichen parallele Ausrichtung des Magnetfeldes zur Strahlachse, wobei diese geringfügig von der vollständigen parallelen Ausrichtung abweicht.

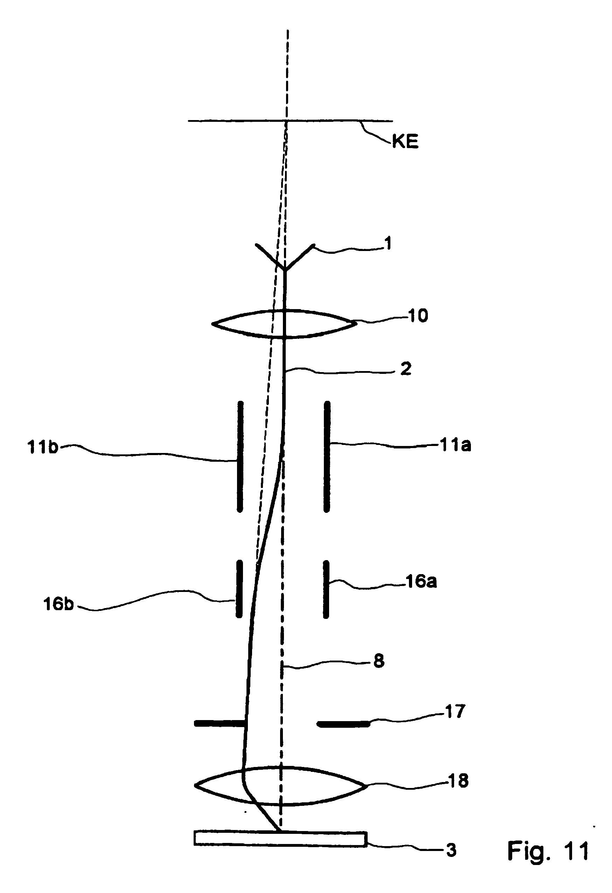

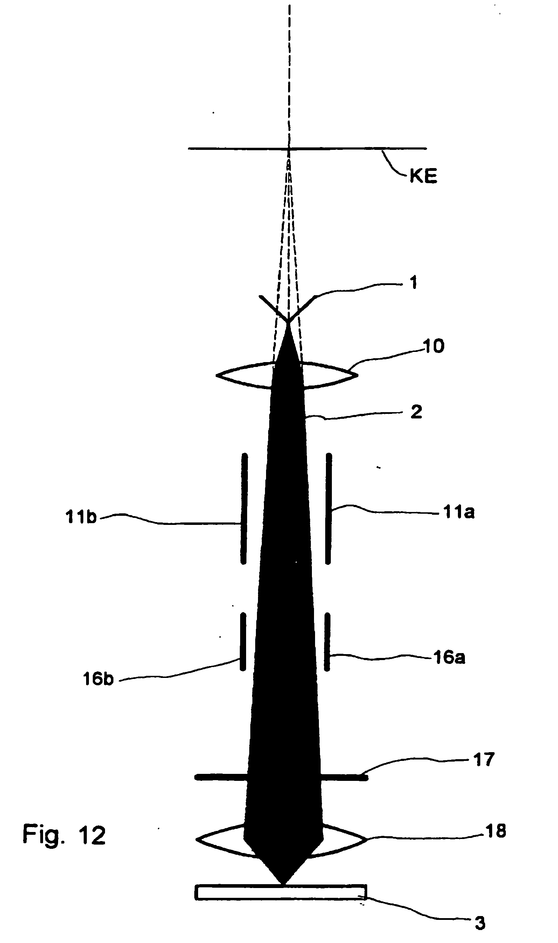

Überlegungen haben ergeben, dass eine gute Auslenkung eines Teilchenstrahls, bei der eine Auswanderung des Teilchenstrahls vermieden wird, dadurch erzielt wird, wenn man Ablenkelemente für den Teilchenstrahl derart anordnet, dass man eine - hinsichtlich eines von einem Ablenkelement gebildeten Bezugssystems - virtuelle, zu einer Objektebene (also eine Ebene, in der ein Objekt liegt) konjugierte Ebene mit berücksichtigt (nachfolgend stets virtuelle konjugierte Ebene genannt), um das Problem der Auswanderung zu lösen. Figuren 11 und 12 zeigen schematisch einen erfindungsgemäßen Aufbau einer Vorrichtung mit einer einen Teilchenstrahl 2 bzw. ein Teilchstrahlbündel 2 erzeugenden Strahlquelle 1, einer Kondensorlinse 10, einem ersten Ablenkelement mit ersten Ablenkplatten 11a und 11b, einem zweiten Ablenkelement mit zweiten Ablenkplatten 16a und 16b, einer Austastblende 17, einer Objektivlinse 18 sowie einem Objekt 3. Die Vorrichtung weist eine Strahlachse 8 auf. Aus Gründen der Übersichtlichkeit ist eine magnetische Einrichtung nicht dargestellt. Auf den Aufbau der erfindungsgemäßen Vorrichtung wird weiter unten noch näher eingegangen. Im Bezugssystem der ersten Ablenkplatten 11a, 11 b liegt die virtuelle konjugierte Ebene KE oberhalb der Strahlquelle 1. Die virtuelle konjugierte Ebene KE wird nun mit berücksichtigt, wenn ein Auswandern des Teilchenstrahls 2 verhindert werden soll, wie nachfolgend näher erläutert. Die virtuelle konjugierte Ebene kann bei einigen Ausführungsbeispielen der Erfindung mit der reellen, zur Objektebene konjugierten Ebene der Vorrichtung zusammenfallen, welche im Bereich der Strahlquelle oder an einem Crossover der von der Strahlquelle emittierten Teilchen liegt.

Die erfindungsgemäße Vorrichtung sieht zunächst die Anordnung von zwei Ablenkelementen vor, die entlang der Strahlachse praktisch "hintereinander" angeordnet sind. Durch eine genaue Anordnung der Ablenkelemente zueinander und vorgebbare Steuerparameter ist es möglich, das virtuelle Zentrum der Auslenkung (virtueller Pivotpunkt) des Teilchenstrahls an eine beliebige Stelle auf der Strahlachse zu legen. Somit ist auch möglich, den virtuellen Pivotpunkt in die virtuelle konjugierte Ebene zu legen. Dies erfolgt durch Verschiebung des virtuellen Pivotpunktes oder durch Verschiebung der virtuellen konjugierten Ebene. Dabei wird die axiale Position des virtuellen Pivotpunktes durch das Verhältnis der beiden Amplituden bestimmt, welche durch die Auslenkungen der beiden Ablenkelemente gegeben sind.

Bei einer bevorzugten Ausführungsform sind das erste Ablenkelement, die magnetische Einrichtung und das zweite Ablenkelement derart steuerbar, dass das virtuelle Zentrum der Auslenkung des Teilchenstrahls in einer auf ein vorgegebenes Bezugssystem (beispielsweise das erste Ablenkelement) bezogenen virtuellen konjugierten Ebene liegt, wobei auch hier die zur Objektebene konjugierte Ebene gemeint ist. Die Steuerung des ersten Ablenkelements, des zweiten Ablenkelements und der magnetischen Einrichtung erfolgt durch geeignete Steuerparameter, beispielsweise einem geeigneten Strom oder eine geeignete Spannung. Die Steuerparameter sind dabei derart aufeinander abgestimmt, dass das virtuelle Zentrum der Auslenkung des Teilchenstrahls in der auf ein Bezugssystem (beispielsweise das erste Ablenkelement) bezogenen virtuellen konjugierten Ebene liegt.

Um ein Auswandern nun zu verhindern, müssen die Anordnung der Ablenkelemente sowie deren vorgebbaren Steuerparameter sehr genau sein, was einen höheren Aufwand nach sich zieht. Um dies zu vermeiden, sind aufgrund der erfindungsgemäßen Anordnung zwei Korrekturabgleche möglich. Der erste Abgleich betrifft die Lage der virtuellen konjugierten Ebene. Wie oben bereits erwähnt, gewährleistet die erfindungsgemäße Anordnung, dass man das virtuelle Zentrum der Auslenkung (virtueller Pivotpunkt) des Teilchenstrahls an eine beliebige Stelle auf der Strahlachse legen kann. Somit ist es möglich, den virtuellen Pivotpunkt in die virtuelle konjugierte Ebene zu legen. Durch eine entsprechende Einstellung eines geeigneten Verhältnisses der Amplituden der Auslenkungen der Ablenkelemente ist stets gewährleistet, dass der virtuelle Pivotpunkt in der virtuellen konjugierten Ebene liegt. Das oben beschriebene "Kippen eines Teilchenstrahls" am Pivotpunkt ist mit der Erfindung ohne weiteres erzielbar. Bei einigen Teilchenstrahlgeräten ist bei dem ersten Abgleich ferner vorgesehen, zusätzlich die Lage der virtuellen konjugierten Ebene mit vorhandenen telichenoptischen Elementen geringfügig zu verschieben. Auch hierdurch wird gewährleistet, dass der virtuelle Pivotpunkt stets in der virtuellen konjugierten Ebene angeordnet ist. Für Teilchenstrahlgeräte, bei denen die Lage der virtuellen konjugierten Ebene nicht beeinflußbar ist, wird eine Lösung weiter unten noch näher beschrieben.

Der zweite Abgleich betrifft die Orientierung der Auslenkung des Teilchenstrahls relativ zur Strahlachse. Eine ausreichend gute Orientierung wird durch das axiale Magnetfeld der magnetischen Einrichtung gewährleistet. Wie oben erwähnt, läßt sich die Orientierung bzw. Richtung der Auslenkung des Teilchenstrahls mit der erfindungsgemäßen Vorrichtung einstellen. Das bereitgestellte Magnetfeld weist vorzugweise eine effektive Länge I auf und ist derart einstellbar, dass eine Larmordrehung des Teilchenstrahls bewirkt wird, die proportional ist zur Stärke und Länge des Magnetfelds:

$$\text{Larmordrehung} \sim B \cdot I \quad \text{[Gleichung 1]}$$

Aufgrund dieses Magnetfeldes mit der entsprechenden Larmordrehung wird eine gewünschte Orientierung der Auslenkung des Teilchenstrahls erzeugt. Überlegungen haben ergeben, dass die Brechkraft des Magnetfeldes der folgenden Bedingung genügt:

$$\text{Brechkraft} \sim B^2 \cdot I \quad \text{[Gleichung 2]}$$

Aufgrund der benötigten kleinen Auslenkungen und des somit kleinen Magnetfeldes ist die Brechkraft jedoch vernachlässigbar.

Im Grunde genommen basiert die Erfindung auch auf dem Gedanken, dass man das Verhältnis der Amplituden der Auslenkungen der Ablenkelemente und die Orientierung der Auslenkrichtungen des Teilchenstrahls durch die Geometrie der Ablenkelemente grob vorgibt. Mit der magnetischen Einrichtung erfolgt dann eine "Feinjustierung" derart, dass der Teilchenstrahl an einem Ort stehen bleibt oder sich nur noch geringfügig bewegt, so dass von einem Auswandern nicht mehr gesprochen werden kann.

Durch die vorgenannte Anordnung der einzelne Elemente der erfindungsgamäßen Vorrichtung und der mit dieser möglichen Korrekturabgleiche ist gewährleistet, dass der Teilchenstrahl auf eine Blende derart ausgelenkt wird, dass ein Auswandern des Teilchenstrahls und somit ein unbsabsichtigtes Beaufschlagen des Objekts mit dem Teilchenstrahl vermieden wird. Im Grunde genommen wird hierdurch erzielt, dass der Teilchenstrahl an einem Ort stehen bleibt bzw, sich nur In einem Bereich derart bewegt, dass von einem Auswandern nicht gesprochen werden kann. Überlegungen haben ergeben, dass die erfindungsgemäße Anordnung es ermöglicht, dass der Teilchenstrahl während eines Austastens (Auslenkens) In einem Bereich von wenigen Nanometer stehen bleibt. Dies Ist besonders bei der Bearbeitung und Herstellung von sehr kleinen Strukturen in Lithographiegeräten von Vorteil.

Bei der Erfindung ist von dem ersten Ablenkelement aus gesehen hinter dem zweiten Ablenkelement mindestens eine Austasteinhelt angeordnet. Diese Austasteinheit ist vorzugsweise als Blende (Austastblende) ausgebildet. Der Teilchenstrahl ist derart In Bereiche der Austasteinheit lenkbar, dass der Teilchenstrahl sich bei der Auslenkung von der ursprünglich eingenommenen Position In der Objektebene nicht oder nur geringfügig entfernt (also von der ursprünglich eingenommenen Position nicht auswandert).

Bei einer weiteren Ausführungsform der Erfindung weist das erste Ablenkelement mindestens zwei erste Ablenkeinheiten auf. Alternativ oder zusätzlich hierzu ist vorgesehen, dass das zweite Ablenkelement mindestens zwei zweite Ablenkeinheiten aufweist. Bei einer weiteren Ausführungsform ist das erste Ablenkelement mit mindestens einer plattenförmigen Ablenkeinheit versehen. Beispielsweise sind die zwei ersten Ablenkeinheiten des ersten Ablenkelements plattenförmig ausgebildet und bilden ein Ablenkplattenpaar. Alternativ oder zusätzlich hierzu ist das zweite Ablenkelement mit mindestens einer plattenförmigen Ablenkeinheit versehen. Auch hier ist beispielsweise vorgesehen, die zwei zweiten Ablenkeinheiten des zweiten Ablenkelements plattenförmig auszubilden, wobei diese dann ein Ablenkplattenpaar bilden.

Wie oben erwähnt, ist es durch geeignete Wahl verschiedener Parameter des ersten Ablenkelements und des zweiten Ablenkelements möglich, den virtuellen Pivotpunkt der Auslenkung des Teilchenstrahls an eine beliebige Stelle auf der Strahlachse zu legen. Zu den Parametern gehören beispielsweise die Länge der beiden Ablenkelemente, der Abstand der Ablenkeinheiten der einzelnen Ablenkelemente zueinander sowie deren Polung und die Versorgung mit Spannung. Bei einem bevorzugten Ausführungsbeispiel beträgt der Abstand der beiden Ablenkeinheiten eines oder eines jeden Ablenkelements ca. 1 mm bis 10mm, vorzugsweise 2mm bis 5mm. Ferner ist es vorzugsweise vorgesehen, dass die zwei ersten Ablenkeinheiten des ersten Ablenkelements und/oder die zwei zweiten Ablenkeinheiten des zweiten Ablenkelements eine Länge im Bereich von 5mm bis 60mm, vorzugsweise im Bereich von 10mm bis 30mm aufweisen.

Bei einer weiteren Ausführungsform der Erfindung weist das erste Ablenkelement mindestens ein erstes magnetisches Element auf. Alternativ oder zusätzlich hierzu weist das zweite Ablenkelement mindestens ein zweites magnetisches Element auf. Beispielsweise sind das erste magnetische Element und das zweite magnetische Element als Ablenkspulen ausgebildet. Diese Ausführungsform geht von dem Grundgedanken aus, dass der beschriebene Effekt auch mit magnetischen Ablankelementen erzielbar ist.

Erfindungsgemäß ist es vorgesehen, dass die Vorrichtung eine einzelne Spannungsversorgungseinheit zur gemeinsamen Versorgung sowohl des ersten Ablenkelements als auch des zweiten Ablenkelements aufweist. Die erfindungsgemäße Anordnung ist von Vorteil, denn jede Spannungsversorgungseinheit Ist mit einer gewissen Ungenauigkeit versehen, so dass hierdurch Fehler In der Ansteuerung des ersten Ablenkelements und des zweiten Ablenkelements auftreten können, was wiederum die Auslenkung des Teilchenstrahls beeinflusst. Durch die Verwendung einer einzelnen Spannungsversorgungseinheit werden derartige Fehler reduziert.

Die mit der ersten und zweiten Spannungsversorgungseinheit bereitgestellten Spannungen $V_1$ und $V_2$ sind Parameter, durch deren geeignete Wahl der virtuelle Pivotpunkt in der virtuellen konjugierten Ebene zu liegen kommt.

Bei einer besonderen Ausführungsform wird das magnetische Feld der magnetischen Einrichtung vorzugsweise mittels mindestens eines Spulenelements erzeugt, welches Teil der magnetischen Einrichtung ist. Vorzugsweise ist auch mindestens ein Polschuh an der magnetischen Einrichtung vorgesehen, welcher das mindestens eine Spulenelement bei der Erzeugung des magnetischen Feldes unterstützt. Es wird aber ausdrücklich darauf hingewiesen, dass die Erfindung nicht darauf eingeschränkt ist, dass das Magnetfeld auf die vorgenannte Art und Weise erzeugt wird. Vielmehr kann das Magnetfeld auf jegliche Art und Weise erzeugt werden.

Bei einer bevorzugten Ausführungsform ist das Magnetfeld der magnetischen Einrichtung derart ausgestaltet, dass es das erste Ablenkelement und/oder das zweite Ablenkelement durchgreift. Bei dieser Ausführungsform ist von Vorteil, dass man nicht durch aufwendige Maßnahmen einen Durchgriff des Magnetfeldes verhindern muß (beispielsweise durch Anordnen von sehr kleinen Öffnungen in Polschuhen und/oder durch einen großen Abstand zwischen der magnetischen Einrichtung mit ihrem Magnetfeld und den Ablenkelementen). Durch Nichtanwenden dieser Maßnahmen läßt sich Bauraum einsparen, insbesondere in axialer Richtung (also im wesentlichen entlang der optischen Achse des Teilchenstrahlgeräts). Es wird aber ausdrücklich darauf hingewiesen, dass der oben beschriebene Durchgriff des Magnetfeldes für die Erfindung nicht zwingend erforderlich ist. Vielmehr ist die Erfindung auch ohne den Durchgriff des Magnetfeldes realisierbar.

Bei einer besonderen Ausführungsform der Erfindung ist die magnetische Einrichtung als Rundlinse ausgebildet. Beispielsweise ist dies eine magnetische Rundlinse eines Teilchenstrahlgeräts, in dem die erfindungsgemäße Vorrichtung angeordnet ist. Die magnetische Rundlinse stellt das für die Erfindung benötigte Magnetfeld bereit. Von Vorteil ist hierbei, dass ein bereits vorhandenes teilchenoptisches Element für die Erfindung verwendet werden kann, so dass Bauteile eingespart werden.

Eine weitere Ausführungsform der Erfindung ist insbesondere dann vorgesehen, wenn die Lage der virtuellen konjugierten Ebene sich nicht beeinflussen läßt. So weist die magnetische Einrichtung dieser weiteren Ausführungsform der Erfindung mindestens einen ersten Bereich mit einem ersten Magnetfeld und mindestens einen zweiten Bereich mit einem zweiten Magnetfeld auf. Das bereits oben genannte Magnetfeld wird im Prinzip in diese zwei Magnetfelder aufgeteilt. Das erste Magnetfeld ist zu dem zweiten Magnetfeld axial entgegengesetzt ausgerichtet. Wegen der nicht vorzeichenbehafteten Magnetfeldabhängigkeit der Brechkraft und der vorzeichenbehafteten Magnetfeldabhängigkeit der Larmordrehung läßt sich dann durch geeignete Wahl des ersten Magnetfeldes und des zweiten Magnetfeldes bei gleichbleibender Larmordrehung die Brechkraft soweit erhöhen, dass man das notwendige Verhältnis der Amplituden der Auslenkungen auf das vorhandene Amplitudenverhältnis anpassen kann. Dabei wird der virtuelle Pivotpunkt verschoben.

Bei einer weiteren Ausführungsform der Erfindung ist/sind das erste Ablenkelement und/oder das zweite Ablenkelement derart angeordnet, dass sie zumindest teilweise mit der magnetischen Einrichtung überlappen. Beispielsweise ist/sind das erste Ablenkelement und/oder das zweite Ablenkelement in die magnetische Einrichtung eingeschoben. Diese Ausführungsform ist insbesondere dann von Vorteil, wenn als magnetische Einrichtung eine bereits in einem Teilchenstrahlgerät existierende Linse verwendet wird. Diese Ausführungsform gewährleistet eine gute Funktion der Erfindung auch bei geringem Bauraum.

Die Erfindung betrifft auch ein Teilchenstrahlgerät mit einer Vorrichtung mit mindestens einem der vorgenannten Merkmale bzw. Merkmalskombinationen. Dabei ist es vorzugsweise vorgesehen, dass das Teilchenstrahlgerät mindestens eine Teilchenquelle zur Erzeugung eines Teilchenstrahls aufweist. Ferner ist das Teilchenstrahlgerät mit mindestens einer Objektivlinse und vorzugsweise mit mindestens einer Kondensorlinse versehen.

Das erfindungsgemäße Teilchenstrahlgerät nach den vorgenannten Ausführungsbeispielen ist vorzugsweise als Lithographiegerät ausgebildet. Insbesondere ist das Teilchenstrahlgerät als Elektronenstrahlgerät ausgebildet. Alternativ hierzu ist das Teilchenstrahlgerät als Ionenstrahlgerät ausgebildet.

Die Erfindung betrifft auch ein Probenbearbeitungsgerät, das mit mindestens einer Teilchenquelle zur Erzeugung eines Teilchenstrahls und mit einer Vorrichtung zur Ablenkung des Teilchenstrahls aus einer Strahlachse des Probenbearbeitungsgeräts oder zur Einlenkung des Teilchenstrahls in die Strahlachse versehen ist. Ferner weist die Vorrichtung mindestens ein Ablenkelement sowie mindestens eine magnetische Einrichtung zur Bereitstellung eines Magnetfeldes auf, das parallel zur Strahlachse ausgerichtet ist, wobei hierzu auch auf die weiter oben gemachten Erläuterungen verwiesen wird. Darüber hinaus ist das Probenbearbeitungsgerät mit mindestens einer Objektivlinse versehen. Von der Teilchenquelle aus gesehen sind an der Strahlachse das Ablenkelement, die magnetische Einrichtung und die Objektivlinse angeordnet. Vorzugsweise ist das bereitgestellte Magnetfeld derart einstellbar, dass eine Larmordrehung von bis zu $\pm$ 90° erzeugt wird, und noch bevorzugter eine Larmordrehung von bis zu $\pm$ 45°.

Diese Ausgestaltung der Erfindung gewährleistet ebenfalls, dass keine ungewünschten Belichtungen während eines Austastens des Teilchenstrahls vorkommen. Hierzu wird der Teilchenstrahl beim Austasten in eine Richtung gelenkt, in der eine zusätzliche Belichtung nicht stört. Aufgrund der Möglichkeit, das Ablenkelement entsprechend beeinflussen zu können (beispielsweise durch Umpolung), reicht eine durch ein einstellbares Magnetfeld bereitgestellte Larmordrehung von max. $\pm$ 90° aus, um während der Austastung jede mögliche Auslenkrichtung des Teilchenstrahls einzustellen. Vorzugsweise Ist das bereitgestellte Magnetfeld derart einstellbar, dass eine Larmordrehung von bis zu $\pm$ 45° oder genau $\pm$ 45° erzeugt wird. Diese Ausführungsform gewährleistet bei entsprechend angesteuertem Ablenkelement, dass der Teilchenstrahl in bestimmte Vorzugsrichtungen orientiert wird.

Bei einer besonderen Ausführungsform des Probenbearbeitungsgeräts weist das Ablenkelement mindestens zwei Ablenkeinheiten auf. Vorzugsweise ist mindestens eine Ablenkeinheit plattenförmig ausgebildet. Sind beispielsweise beide Ablenkeinheiten plattenförmig ausgebildet, so bilden sie ein Ablenkplattenpaar.

Ferner ist das Probenbearbeitungsgerät vorzugsweise mit einer Spannungsversorgungseinheit zur Versorgung des Ablenkelementes versehen.

Bei einer besonderen Ausführungsform des Probenbearbeitungsgeräts wird das magnetische Feld der magnetischen Einrichtung vorzugsweise mittels mindestens eines Spulenelements erzeugt, welches Teil der magnetischen Einrichtung ist. Vorzugsweise ist auch mindestens ein Polschuh an der magnetischen Einrichtung vorgesehen, welcher beispielsweise das mindestens eine Spulenelement bei der Erzeugung des magnetischen Feldes unterstützt. Auch hier wird nochmals darauf hingewiesen, dass die Erfindung auf diese Erzeugung des Magnetfeldes nicht eingeschränkt ist. Vielmehr kann das Magnetfeld auf jegliche Art und Weise erzeugt werden. Bei einer weiteren bevorzugten Ausführungsform ist das Magnetfeld der magnetischen Einrichtung derart ausgestaltet, dass es das Ablenkelement durchgreift.

Bei einer besonderen Ausführungsform des Probenbearbeitungsgeräts ist die magnetische Einrichtung als Rundlinse ausgebildet. Beispielsweise ist dies eine magnetische Rundlinse eines Teilchenstrahlgeräts, in dem die Ablenkvorrichtung (bzw. Einlenkvorrichtung) angeordnet ist. Die magnetische Rundlinse stellt das für die Erfindung benötigte Magnetfeld mit der entsprechenden Larmordrehung bereit. Von Vorteil ist hierbei, dass ein bereits vorhandenes teilchenoptisches Element für die Erfindung verwendet werden kann, so dass Bauteile eingespart werden.

Nachfolgend wird die Erfindung anhand von Ausführungsbeispielen mittels Figuren näher erläutert. Dabei zeigen

Fig. 1    ein Teilchenstrahlgerät mit einer Ablenkvorrichtung nach dem Stand der Technik;

Fig. 2    ein Teilchenstrahlgerät mit einer Vorrichtung zur Ablenkung und Einlenkung eines Teilchenstrahls sowie mit zwei Spannungsversorgungseinheiten, welches nicht teil der Erfindung ist.

Fig. 3    ein erfindungsgemäßes Teilchenstrahlgerät nach Figur 2 mit nur einer Spannungsversorgungseinheit;

Fig. 4    ein Telichenstrahlgerät nach Figur 2, jedoch mit Spulenelementen;

Fig. 5    ein Teilchenstrahlgerät mit einer Vorrichtung zur Ablenkung und Einlenkung eines Teilchenstrahls mit entgegengesetzten Magnetfeldern und mit zwei Spannungsversorgungseinheiten, welches nicht teil der Erfindung ist.

Fig. 6       ein erfindungsgemäßes Teilchenstrahlgerät nach Figur 5 mit nur einer Spannungsversorgungseinheit;

Fig. 7       ein Teilchenstrahlgerät nach Figur 5, jedoch mit Spulenelementen;

Fig. 8       ein Teilchenstrahlgerät mit einer weiteren Vorrichtung zur Ablenkung eines Teilchenstrahls;

Fig. 9       einen Verlauf eines Magnetfeldes der Vorrichtung nach Figur 2;

Fig. 10      einen Verlauf eines Magnetfeldes der Vorrichtung nach Figur 5;

Fig. 11      einen schematischen Aufbau eines Teilchenstrahlgeräts;

Fig. 12      einen weiteren schematischen Aufbau eines Teilchenstrahlgeräts; und

Fig. 13      eine schematische Darstellung von Anordnungen von Ablenkelementen und einer magnetischen Einrichtung.

Die nachfolgend beschriebenen Ausführungsbeispiele von Vorrichtungen zur Ablenkung und Einlenkung eines Teilchenstrahls (nachfolgend auch nur Ablenkvorrichtungen genannt) sind in Teilchenstrahlgeräten angeordnet, die als Lithographiegeräte ausgebildet sind. Dabei handelt es sich bei den in den Figuren dargestellten Ausführungsbeispielen um Elektronenstrahlgeräte oder Ionenstrahlgeräte. Die in den Figuren dargestellten Teilchenstrahlgeräte bzw. auch die bereits weiter oben beschriebenen Teilchenstrahlgeräte können aber auch beispielsweise als Rasterelektronenmikroskop oder auch Transmissionselektronenmikroskop ausgebildet sein, denn auch bei derartigen Geräten ist es In manchen Fällen notwendig, einen Elektronenstrahl auszutasten, um eine Schädigung einer zu untersuchenden Probe zu verhindern.

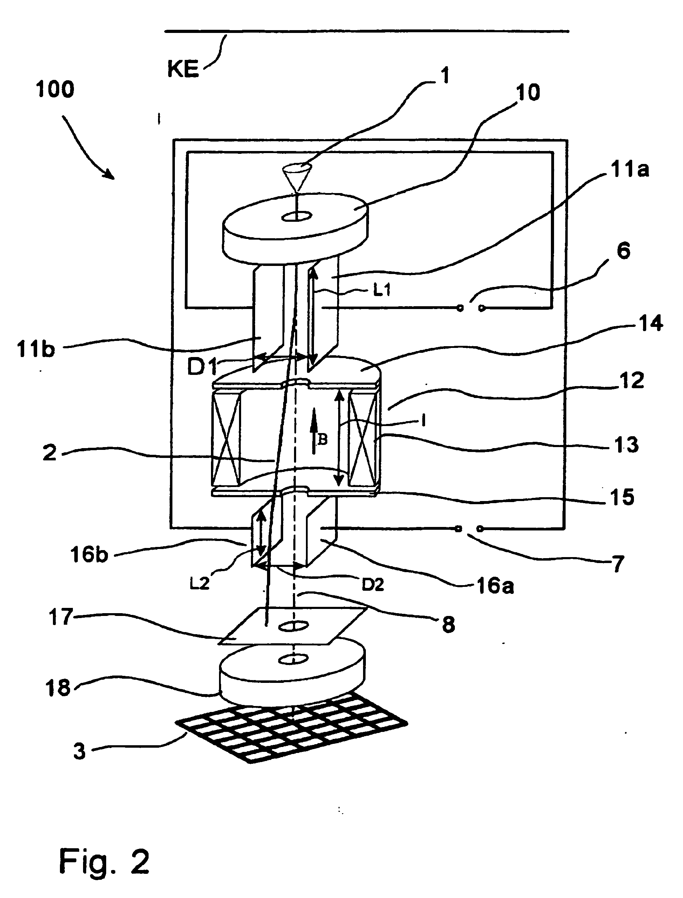

Figur 2 zeigt ein Teilchenstrahlgerät 100, das eine Strahlquelle 1 zur Erzeugung eines Teilchenstrahls 2 aufweist. Ferner ist das Teilchenstrahlgerät 100 mit einer Kondensorlinse 10 und einer Objektivlinse 18 versehen. Die Funktionsweise der Kondensorlinse 10 und der Objektivlinse 18 sind bereits seit langem bekannt, so dass hier darauf nicht weiter eingegangen wird. Von der Strahlquelle 1 aus gesehen ist entlang einer Strahlachse 8 hinter der Kondensorlinse 10 ein erstes Ablenkelement angeordnet, welches aus zwei sich gegenüberliegenden ersten Ablenkplatten 11a und 11 b besteht. Die ersten Ablenkplatten 11a und 11b sind im Grunde identisch aufgebaut und weisen jeweils eine Länge L1 im Bereich von ca. 20mm auf. Der Abstand D1 der ersten Ablenkplatten 11a und 11b voneinander liegt bei diesem illustrativen Beispiel bei ca. 4mm. Bei einer alternativen Anordnung des ersten Ablenkelements weisen die beiden ersten Ablenkplatten 11a und 11 b eine Länge L1 im Bereich von ca. 10mm auf, wobei dann die beiden ersten Ablenkplatten 11a und 11 b einen Abstand voneinander von ca. 2mm aufweisen. Die Länge L1 der ersten Ablenkplatten 11a und 11 b ist dabei entlang der Strahlachse 8 gemessen. Der Abstand D1 der beiden ersten Ablenkplatten 11a und 11 b ist senkrecht zur Strahlachse 8 gemessen. Das erste Ablenkelement bildet somit ein Ablenkplattenpaar.

Hinter den ersten Ablenkplatten 11a, 11 b ist entlang der Strahlachse 8 eine magnetische Einrichtung 12 angeordnet, welche zwei Polschuhplatten 14 und 15 sowie ein Spulenelement 13 aufweist. Die magnetische Einrichtung 12 ist als magnetische Rundlinse ausgebildet und erzeugt ein magnetisches Feld B, welches parallel zur Strahlachse 8 (also axial zur Strahlachse 8) orientiert ist. Hierauf wird weiter unten näher eingegangen.

Entlang der Strahlachse 8 ist - von der Strahlquelle 1 aus gesehen - hinter der magnetischen Einrichtung 12 ein zweites Ablenkelement angeordnet. Das zweite Ablenkelement weist zwei sich gegenüberliegende zweite Ablenkplatten 16a und 16b auf, welche ein Ablenkplattenpaar bilden. Die beiden zweiten Ablenkplatten 16a und 16b weisen einen Abstand D2 von ca. 4mm voneinander auf. Auch die zweiten Ablenkplatten 16a und 16b sind im Grunde identisch zueinander ausgebildet und weisen eine Länge L2 von ca. 10mm auf. Die Länge L2 der zweiten Ablenkplatten 16a und 16b ist dabei entlang der Strahlachse 8 gemessen. Der Abstand D2 der zweiten Ablenkplatten 16a und 16b ist senkrecht zur Strahlachse 8 gemessen.

Bei dem in Figur 2 dargestellten illustrativen Beispiel beträgt der Abstand von der Strahlquelle 1 zu einer Mitte zwischen einer vorderen Kante und einer hinteren Kante der ersten Ablenkplatten 11a und 11b ca. 100mm. Die vordere Kante ist dabei zur Strahlquelle 1 gerichtet. Die Mitte der ersten Ablenkplatten 11a, 11 b ist der Ort, an dem effektiv eine Auslenkung des Teilchenstrahls erfolgt. Da die Länge L1 der ersten Ablenkplatten 11 a und 11 b bei der dargestellten Anordnung 20mm beträgt, beträgt der Abstand der vorderen Kante zur Strahlquelle 1 demnach ca. 90mm.

Ferner beträgt der Abstand von der Strahlquelle 1 zu einer Mitte zwischen einer vorderen Kante und einer hinteren Kante der zweiten Ablenkplatten 16a und 16b ca. 250mm. Die vordere Kante ist dabei zur Strahlquelle 1 gerichtet.Die Mitte der zweiten Ablenkplatten 16a und 16b ist der Ort, an dem effektiv eine Auslenkung des Teilchenstrahls erfolgt. Da die Länge L2 der zweiten Ablenkplatten 16a und 16b ca. 10mm beträgt, beträgt der Abstand der der vorderen Kante zur Strahlquelle 1 ca. 245mm.

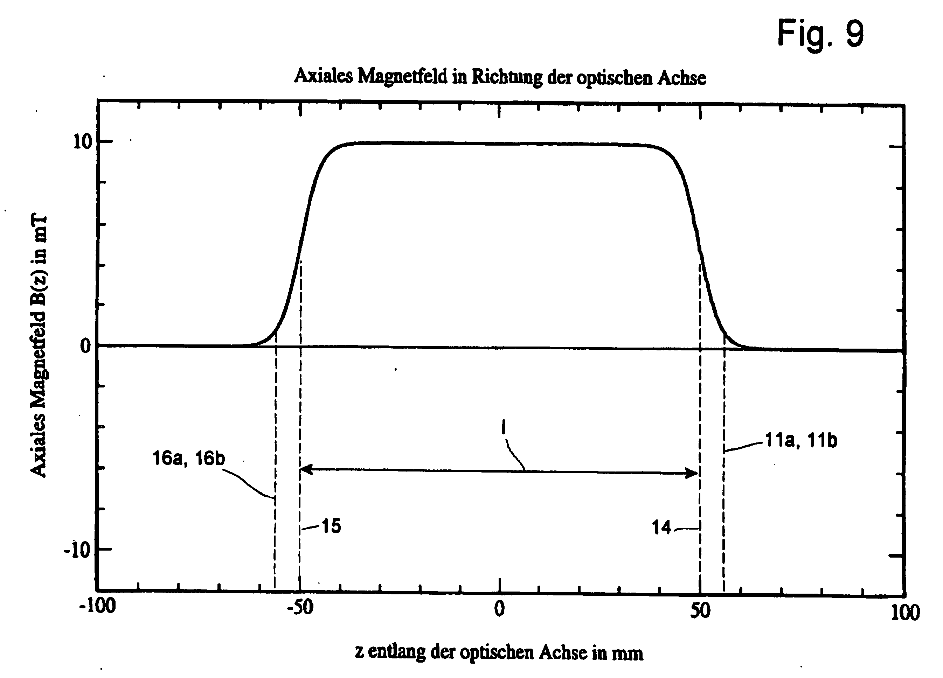

Die oben genannte magnetische Rundlinse ist Teil des Teilchenstrahlgeräts 100, die noch weitere Funktionen wahrnimmt, welche aber durch die für die Erfindung wesentliche Funktion nicht gestört werden. Die Orientierung des magnetischen Feldes B ist in Figur 2 mit einem Pfeil gekennzeichnet. Das Magnetfeld B ist dabei derart ausgestaltet, dass es sowohl das erste Ablenkelement mit den ersten Ablenkplatten 11 a und 11b als auch das zweite Ablenkelement mit den zweiten Ablenkplatten 16a und 16b durchgreift und eine effektive Länge l aufweist, welche im wesentlichen dem Abstand der beiden zueinander gerichteten Seiten der Polschuhplatten 14 und 15 entspricht. Der genaue Verlauf des Magnetfeldes B, welches in der Größenordnung von einigen Millitesla liegt, ist aus der Figur 9 ersichtlich. Aufgetragen ist dort die Magnetfeldstärke B in Abhängigkeit der z-Achse, welche entlang der Strahlachse 8 bzw. optischen Achse verläuft. Der Nullpunkt ist hier die Mitte der magnetischen Einrichtung 12. Die Position der Polschuhplatte 14 ist bei ca. z=50mm, während die Position der Polschuhplatte 15 bei ca. z= -50mm ist. Die effektive Länge l beträgt bei diesem Ausführungsbeispiel daher ca. 100mm. Der Durchgriff des Magnetfeldes B ist aus der Figur 9 ebenfalls ersichtlich. So zeigt Figur 9 die ungefähren Positionen der ersten Ablenkplatten 11a und 11b sowie der zweiten Ablenkplatten 16a und 16b, an denen noch ein gewisses Magnetfeld B vorhanden ist.

Wie bereits weiter oben erwähnt, ist der Durchgriff des Magnetfeldes B für die Erfindung nicht zwingend erforderlich. Er ist jedoch ein bevorzugtes Merkmal der Erfindung und hier vorteilhaft, da keine aufwendigen Maßnahmen getroffen werden müssen, welche den Durchgriff minimieren. Somit wird Bauraum eingespart.

Hinter den zweiten Ablenkplatten 16a und 16b sind - wiederum von der Strahlquelle 1 aus gesehen - eine Austastblende 17 und die Objektivlinse 18 angeordnet, die den Teilchenstrahl 2 (beispielsweise ein Elektronenstrahl oder Ionenstrahl) in eine Objektebene fokussiert, in der das Objekt 3 angeordnet ist. Dieses kann dadurch geschehen, dass das System bestehend aus der Kondensorlinse 10, der magnetischen Einrichtung 12 und der Objektivlinse 18 die Strahlquelle 1 oder deren sogenannter Crossover (also der Punkt nahe der Strahlquelle 1, in dem die von der Strahlquelle 1 emittierten Teilchen den kleinsten Strahldurchmesser senkrecht zur Strahlachse 8 aufweisen) in die Objektebene abbildet. Insofern weist das Teilchenstrahlgerät 100 von der Strahlquelle 1 aus gesehen die folgende Anordnung auf: erste Ablenkplatten 11a und 11b - magnetische Einrichtung 12 - zweite Ablenkplatten 16a und 16b - Austastblende 17 - Objektivlinse 18 - Objekt 3.

Die Orientierung der beiden Ablenkelemente zueinander (also die relative Ausrichtung des ersten Ablenkelements und des zweiten Ablenkelements zueinander) beträgt bei dem hier dargestellten Ausführungsbeispiel 0° (wobei das Verhältnis der Spannungen hier $V_1/V_2$= -1 ist, worauf weiter unten noch näher eingegangen wird). Alternativ hierzu ist vorgesehen, die beiden Ablenkelemente um 180° zueinander auszurichten (wobei das Verhältnis der Spannungen hier $V_1/V_2$= 1 ist, worauf weiter unten noch näher eingegangen wird).

Ferner ist bei dem vorgenannten Ausführungsbeispiel die Kondensorlinse 10 etwas erregt. Die magnetische Einrichtung 12 Ist nur ganz schwach erregt.

Das Ablenkplattenpaar bestehend aus den ersten Ablenkplatten 11a und 11b wird bei dieser Anordnung mittels einer ersten Spannungsversorgungseinheit 6 mit einer Spannung $V_1$ versorgt. Ferner ist eine zweite Spannungsversorgungseinheit 7 vorgesehen, die eine Spannung $V_2$ zur Verfügung stellt und zur Versorgung des Ablenkplattenpaares bestehend aus den zweiten Ablenkplatten 16a und 16b vorgesehen ist. Die ersten Ablenkplatten 11a und 11b sind dementsprechend über Leitungen mit der ersten Spannungsversorgungseinheit 6 verbunden. Hingegen sind die zweiten Ablenkplatten 16a und 16b über Leitungen mit der zweiten Spannungsversorgungseinheit 7 verbunden.

Etwas oberhalb der Strahlquelle 1 liegt die zur Objektebene virtuelle konjugierte Ebene KE hinsichtlich des von dem ersten Ablenkplattenpaar 11a, 11b gebildeten Bezugsystems. Die Lage dieser virtuellen konjugierten Ebene KE läßt sich bei dem dargestellten Ausführungsbeispiel geringfügig durch eine Einstellung der im Teilchenstrahlgerät 100 vorhandenen teilchenoptischen Einheiten, insbesondere der Kondensorlinse 10 verschieben. Die Kondensorlinse 10 ist zwischen der Strahlquelle 1 und dem ersten Ablenkplattenpaar 11a, 11b angeordnet und ist - wie oben erwähnt - in der Regel schwach erregt. Aufgrund dessen verschiebt sie die virtuelle konjugierte Ebene KE von dem Objekt 3 weg.

Wenn die Erregung der Kondensorlinse 10 geändert wird, dann muß man auch die Erregung der Objektivlinse 18 ändern, um den Fokus des Teilchenstrahls 2 in der Objektebene aufrecht zu erhalten. Die Ebene der Strahlquelle 1 verbleibt somit immer konjugiert zur Objektebene. Zwischen der Kondensorlinse 10 und der Objektivlinse 18 ändert sich jedoch der Teilchenstrahl 2 und die virtuelle Fokusebene in diesem Bereich verschiebt sich. Diese virtuelle Fokusebene ist auch diejenige Ebene (virtuelle konjugierte Ebene), welche für das erste und das zweite Ablenkelement maßgeblich ist. Durch geeignete Wahl der Lage der virtuellen konjugierten Ebene kann man eine Justierung der Auslenkung des Teilchenstrahls 2 vornehmen, wie nachfolgend erläutert wird.

Mittels der ersten Spannungsversorgungseinheit 6 und der zweiten Spannungsversorgungseinheit 7 läßt sich das Verhältnis der Spannungen $V_1$ und $V_2$ - wie oben genannt - derart einstellen, dass aufgrund des Verhältnisses der Amplituden der Auslenkungen der ersten Ablenkplatten 11a, 11b bzw. der zweiten Ablenkplatten 16a, 16b der virtuelle Pivotpunkt an einem gewünschten Punkt auf der Strahlachse 8 in der virtuellen konjugierten Ebene KE liegt (es läßt sich somit die axiale Position des Pivotpunktes einstellen). Die Einstellung der Position erfolgt durch eine Verschiebung der virtuellen konjugierten Ebene. Wie bereits erwähnt, liegt bei dem dargestellten Ausführungsbeispiel die virtuelle konjugierte Ebene KE oberhalb der Strahlquelle 1. Die Lage der virtuellen konjugierten Ebene KE läßt sich auch noch durch die Erregung der Kondensorlinse 10 beeinflussen, wobei die Erregung der Objektivlinse 18 immer soweit nachgestellt wird, dass die Fokussierung des Teilchenstrahls 2 auf dem Objekt 3 erhalten bleibt. Die zur Strahlachse 8 azimuthale Orientierung der durch die ersten Ablenkplatten 11a und 11 b hervorgerufene Auslenkung des Teilchenstrahls 2 auf dem Objekt 3 wird durch das von der magnetischen Einrichtung 12 bereitgestellte Magnetfeld B bestimmt.

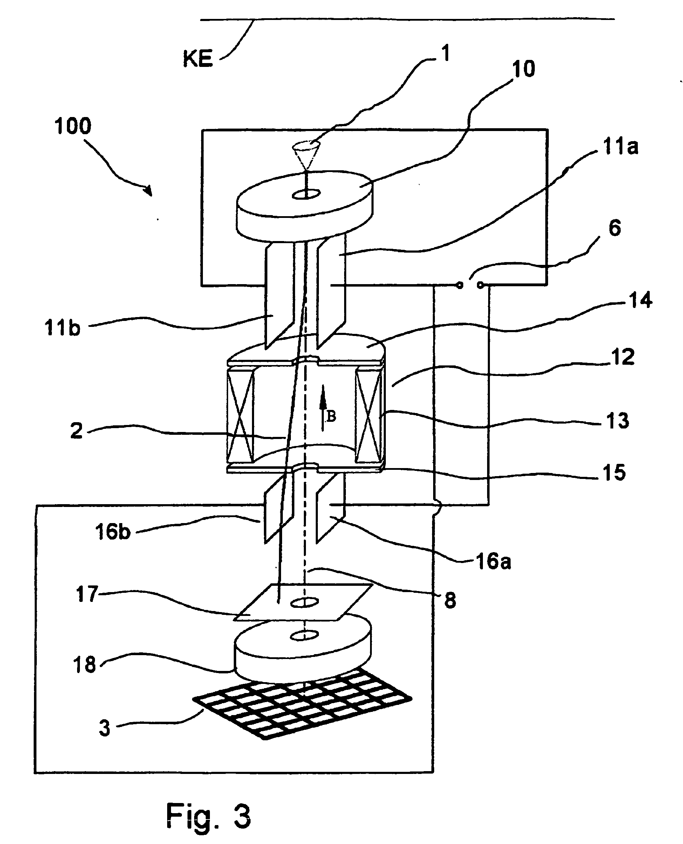

Eine erfindungsgemäße Anordnung ist in Figur 3 dargestellt, wobei gleiche Bezugszeichen gleiche Bauteile bezeichnen. Das in Figur 3 dargestellte Ausführungsbeispiel unterscheidet sich von dem in Figur 2 dargestellten illustrativen Beispiel nur dahingehend, dass die ersten Ablenkplatten 11a, 11b sowie zweiten Ablenkplatten 16a und 16b aus einer einzelnen Spannungsversorgungseinheit, nämlich der ersten Spannungsversorgungseinheit 6 mit Spannung versorgt werden. Ansonsten sind die Merkmale des Ausführungsbeispieles gemäß Figur 3, insbesondere die Ausbildung der ersten und zweiten Ablenkplatten 11a, 11 b, 16a und 16b, identisch zu dem illustrativen Beispiel gemäß Figur 2 ausgebildet. Im Unterschied zum illustrativen Beispiel gemäß Figur 2 läßt sich ein Verhältnis von Spannungen nicht einstellen, da nur eine einzelne Spannungsversorgungseinheit 6 verwendet wird. Es ist demnach ein festes Verhältnis der Spannungen vorgegeben. Bei dem hier dargestellten Ausführungsbeispiel ist ein Verhältnis von $V_1/V_2 = 1$ vorgegeben (Orientierung der beiden Ablenkelemente zueinander 180°). Die erfindungsgemäße Anordnung gemäß Figur 3 weist den Vorteil auf, dass Fehler aufgrund von möglichen Ungenauigkeiten des Spannungsverhältnisses mehrerer Spannungsversorgungseinheiten, welche die Einstellung des virtuellen Pivotpunktes beeinflussen, verringert werden. Im Nanosekundenbereich ist es eigentlich stets möglich, ein festes Verhältnis der Spannungen zu gewährleisten. Überlegungen haben ergeben, dass dies bei kurzgeschlossenen ersten und zweiten Ablenkplatten 11a, 11 b, 16a und 16b (also bei einem festen Verhältnis der Spannungen von $V_1/V_2 = 1$ oder $V_1/V_2 = -1$) am besten zu realisieren ist. Die Erfindung gewährleistet, dass der Teilchenstrahl 2 am Objekt 3 bei der Austastung in einem vernachlässigbaren Bereich (Nanometerbereich) stehen bleibt. Bei einer alternativen Ausführungsform der Erfindung ist es vorgesehen, dass das zweite Ablenkelement halb so stark den Teilchenstrahl 2 zurücklenken muß, wie das erste Ablenkelement den Teilchenstrahl 2 auslenkt. Bei einer alternativen Anordnung kann man dann das erste Ablenkelement und das zweite Ablenkelement von den Dimensionen her identisch ausbilden und als Verhältnis der Spannungen $V_1/V_2 = -2$ wählen. Allerdings kann man auch die Länge des zweiten Ablenkelements halbieren und erfindungsgemäß als Verhältnis der Spannungen $V_1/V_2 = -1$ wählen.

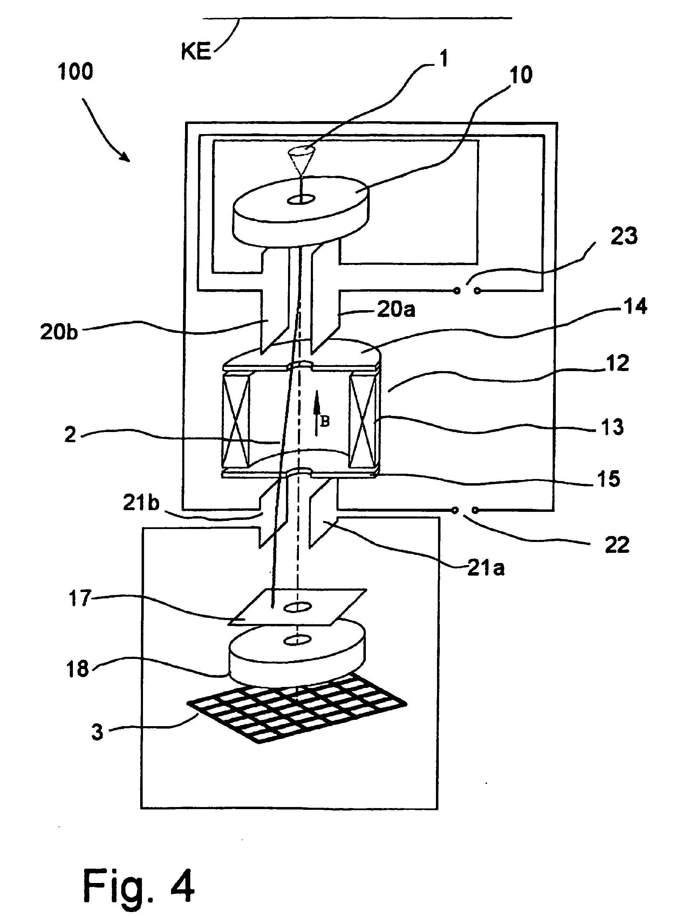

Ein weiteres zu dem illustrativen Beispiel gemäß Figur 2 sehr verwandtes illustratives Beispiel in Figur 4 dargestellt, wobei gleiche Bezugszeichen gleiche Bauteile bezeichnen. Das in Figur 4 dargestellte illustrative Beispiel unterscheidet sich von dem in Figur 2 dargestellten illustrativen Beispiel nur dahingehend, dass statt Ablenkplatten erste Spulenelemente 20a, 20b und zweite Spulenelemente 21a, 21b zur Erzeugung eines auslenkenden Magnetfeldes verwendet werden, die durch entsprechende erste und zweite Versorgungseinheiten 22 sowie 23 versorgt werden.

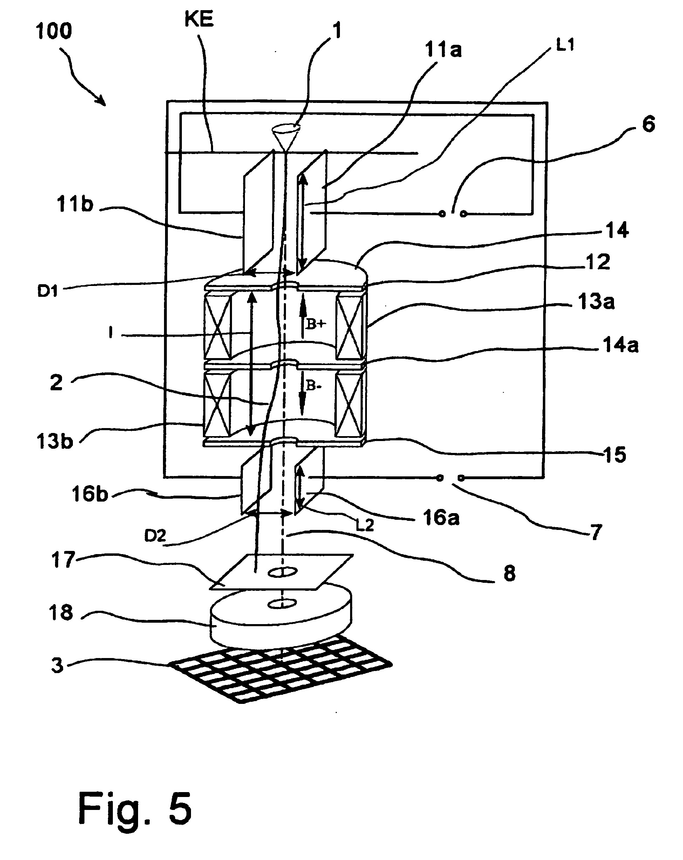

Ein weiteres illustratives Beispiel ist in Figur 5 dargestellt. Figur 5 zeigt wiederum ein Teilchenstrahlgerät 100, wobei wiederum gleiche Bezugszeichen gleiche Bauteile bezeichnen. Auch dieses illustrative Beispiel ist mit einer Strahlquelle 1 zur Erzeugung eines Teilchenstrahls 2 versehen und weist eine Strahlachse 8 auf, entlang derer weitere Bauteile des Teilchenstrahlgeräts 100 von der Strahlquelle 1 aus gesehen in einer bestimmten Reihenfolge angeordnet sind. Hinter der Strahlquelle 1 ist wiederum ein erstes Ablenkelement mit zwei sich gegenüberliegenden ersten Ablenkplatten 11a und 11b angeordnet, an der sich eine magnetische Einrichtung 12 anschließt. Das erste Ablenkelement bildet somit ein Ablenkplattenpaar. Die ersten Ablenkplatten 11a und 11b sind im Grunde identisch aufgebaut und weisen jeweils eine Länge L1 im Bereich von ca. 30mm auf. Der Abstand D1 der ersten Ablenkplatten 11a und 11 b voneinander liegt bei diesem Ausführungsbeispiel bei ca. 4mm. Bei einer alternativen Anordnung des ersten Ablenkelements weisen die beiden ersten Ablenkplatten 11a und 11b eine Länge L1 im Bereich von ca. 15mm auf, wobei dann die beiden ersten Ablenkplatten 11a und 11b einen Abstand D1 voneinander von ca. 2mm aufweisen. Die Länge L1 der ersten Ablenkplatten 11 a und 11 b ist dabei entlang der Strahlachse 8 gemessen. Der Abstand D1 der ersten Ablenkplatten 11a und 11 b ist senkrecht zur Strahlachse 8 gemessen.

Der magnetischen Einrichtung 12 ist ein zweites Ablenkelement mit zwei sich gegenüberliegenden zweiten Ablenkplatten 16a und 16b nachgeordnet, an das sich eine Austastblende 17 anschließt. Die beiden zweiten Ablenkplatten 16a und 16b weisen einen Abstand D2 von ca. 4mm voneinander auf. Auch die zweiten Ablenkplatten 16a und 16b sind im Grunde identisch ausgebildet und weisen eine Länge L2 von ca. 10mm auf. Die Länge L2 der zweiten Ablenkplatten 16a und 16b ist dabei entlang der Strahlachse 8 gemessen. Der Abstand D2 der zweiten Ablenkplatten 16a und 1b ist senkrecht zur Strahlachse 8 gemessen.

Hinter der Austastblende 17 ist eine Objektivlinse 18 angeordnet, hinter der ein Objekt 3 angeordnet ist. Das Objekt 3 liegt in einer Objektebene. Somit weist das Teilchenstrahlgerät 100 von der Strahlquelle 1 aus gesehen die folgende Anordnung von Bauteilen auf: erstes Ablenkelement mit ersten Ablenkplatten 11 a und 11b - magnetische Einrichtung 12 - zweites Ablenkelement mit zweiten Ablenkplatten 16a und 16b - Austastblende 17 - Objektivlinse 18 - Objekt 3.

Bei dem in Figur 5 dargestellten illustrativen Beispiel beträgt der Abstand von der Strahlquelle 1 zu einer Mitte zwischen einer vorderen Kante und einer hinteren Kante der ersten Ablenkplatten 11a und 11b ca. 50mm, wobei die Mitte der einzelnen Ablenkplatten durch die bereits oben gegebene Definition gegeben ist. Die vordere Kante ist dabei zur Strahlquelle 1 gerichtet. Bei einer Länge L1 von ca. 30mm der ersten Ablenkplatten 11a und 11b beträgt demnach der Abstand zwischen der vorderen Kante und der Strahlquelle 1 ca. 35mm.

Der Abstand von der Strahlquelle 1 zu einer Mitte zwischen einer vorderen Kante und einer hinteren Kante der zweiten Ablenkplatten 16a und 16b beträgt ca. 200mm, wobei hinsichtlich der Definition der Mitte auf weiter oben verwiesen wird. Die vordere Kante ist dabei zur Strahlquelle 1 gerichtet. Bei einer Länge L2 von 10mm der zweiten Ablenkplatten 16a und 16b beträgt demnach der Abstand zwischen der vorderen Kante und der Strahlquelle 1 ca. 195mm.

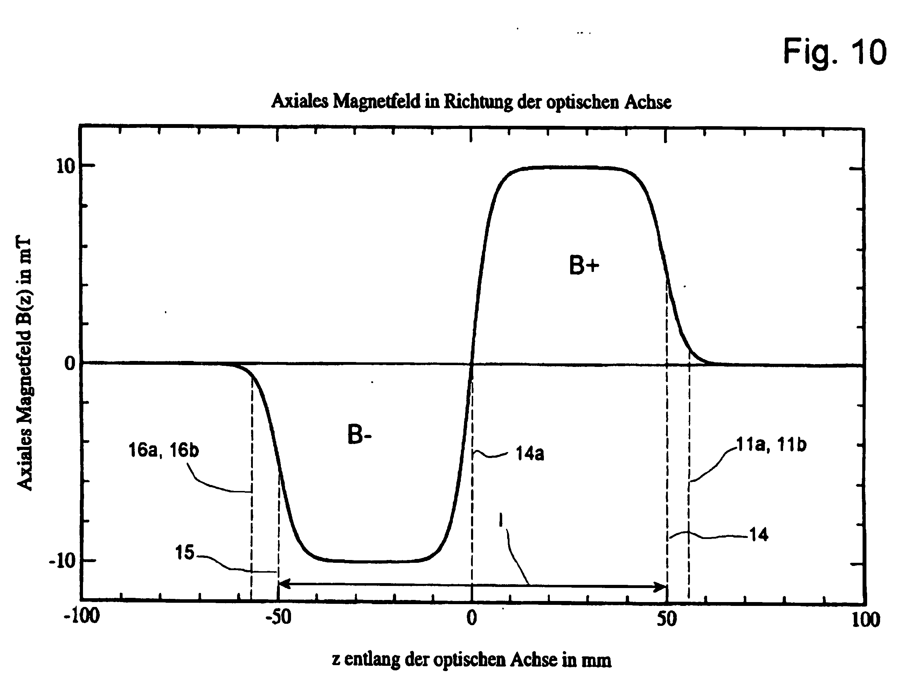

Die magnetische Einrichtung weist Polschuhplatten 14, 14a und 15 auf, wobei zwischen den Polschuhplatten 14 und 14a ein Spulenelement 13a angeordnet ist, während zwischen den Polschuhplatten 14a und 15 ein weiteres Spulenelement 13b angeordnet ist. Das Spulenelement 13a umfaßt einen ersten Bereich, in dem ein axial zur Strahlachse 8 ausgerichtetes erstes Magnetfeld $B_+$ erzeugt wird. Hingegen umfaßt das Spulenelement 13b einen zweiten Bereich, in dem ein axial zur Strahlachse 8 ausgerichtetes zweites Magnetfeld $B_-$ erzeugt wird. Die Ausrichtung der beiden Magnetfelder $B_+$ und $B_-$ ist zueinander entgegengesetzt, was durch die entsprechenden Pfeile in Figur 5 kenntlich gemacht ist. Auch hier weist das Magnetfeld, welches sich aus den beiden Magnetfeldern $B_+$ und B. zusammensetzt, eine effektive Länge **I** auf, die in Figur 5 entsprechend gekennzeichnet ist. Der genaue Verlauf des Magnetfeldes B, welches in der Größenordnung von einigen Millitesia liegt, ist aus der Figur 10 ersichtlich. Aufgetragen ist dort die Magnetfeldstärke in Abhängigkeit der z-Achse, welche entlang der Strahlachse 8 bzw. optischen Achse verläuft. Der Nullpunkt ist hier die Mitte der magnetischen Einrichtung 12. Die Position der Polschuhplatte 14 ist bei ca. z=50mm, die Position der Polschuhplatte 15 ist bei ca. z= -50mm ist, und die Position der Polschuhplatte 14a ist bei ca. z= 0mm. Die effektive Länge **I** beträgt bei diesem Ausführungsbeispiel daher ca. 100mm. Auch bei diesem Ausführungsbeispiel ist ein Durchgriff der Magnetfelder $B_+$ und B. vorgesehen, was aus der Figur 10 ersichtlich ist. So zeigt Figur 10 die ungefähren Positionen der ersten Ablenkplatten 11a und 11b sowie der zweiten Ablenkplatten 16a und 16b, an denen noch ein gewisses Magnetfeld $B_+$ oder B. vorhanden ist.

Die Orientierung der beiden Ablenkelemente zueinander (also die relative Ausrichtung des ersten Ablenkelements und des zweiten Ablenkelements zueinander) beträgt bei dem hier dargestellten Ausführungsbeispiel 180°, wobei das Spannungsverhältnis hier $V_1/V_2$= 1 ist. Die Orientierung der beiden Ablenkelemente hängt aber von der Stärke der magnetischen Einrichtung 12 ab. Sollte die magnetische Einrichtung 12 beispielsweise stark ausgebildet sein, so dass eine Larmordrehung von beispielsweise 50° erzielt werden kann, so muß man die Orientierung der beiden Ablenkelemente zueinander entsprechend ändern (beispielsweise auf 230°).

Bei dem in Figur 5 dargestellten illustrativen Beispiel läßt sich die virtuelle konjugierte Ebene KE nicht ohne weiteres einstellen und verschieben, weil eine Kondensorlinse nicht vorgesehen ist. Aus diesem Grunde wurden bei dem hier darstellten Ausführungsbeispiel die zwei magnetischen Bereiche mit den zueinander entgegengesetzten und parallel zur Strahlachse 8 ausgerichteten Magnetfeldern $B_+$ und B. gewählt, wobei die Beträge der Magnetfelder $B_+$ und B. ungefähr gleich groß sind.

Bei dem in Figur 5 dargestellten illustrativen Beispiel ist es möglich, die axiale Position des virtuellen Pivotpunktes der Auslenkung des Teilchenstrahls 2 auf der Strahlachse 8 auf zwei Arten einzustellen. Zum einen kann die axiale Position des virtuellen Pivotpunktes mittels einer geeigneten Wahl von $B_+$ und B. erfolgen. Aufgrund der nicht vorzeichenbehafteten Brechkraft und der vorzeichenbehafteten Magnetfeldabhängigkeit der Larmordrehung läßt sich die Brechkraft durch eine geeignete Wahl von $B_+$ und $B_-$ derart erhöhen, dass man wiederum das für eine Auslenkung ohne Auswanderung des Teilchenstrahls notwendige Verhältnis der Amplituden der Auslenkungen der beiden Ablenkelemente erhalten kann. Dies bedeutet, dass man auch bei diesem Ausführungsbeispiel den virtuellen Pivotpunkt wieder in die virtuelle konjugierte Ebene KE legen kann. Mit anderen Worten ausgedrückt kann mittels der Magnetfelder $B_+$ und $B_-$ über die Brechkraft ein Abgleich hinsichtlich der Länge der Ablenkelemente durchgeführt werden, wobei die Larmordrehung gleich bleibt. Mit einer geringen Differenz zwischen den Magnetfeldern $B_+$ und $B_-$ wird ein Abgleich bezüglich der Orientierung der beiden Ablenkelemente zueinander durchgeführt, wobei die Brechkraft sich nur unwesentlich ändert.

Zusätzlich kann die axiale Position des virtuellen Pivotpunktes durch eine geeignete Wahl des Verhältnisses der Amplituden der Ablenkspannungen $V_1$ und $V_2$ eingestellt werden, die durch eine erste Spannungsversorgungseinheit 6 und eine zweite Spannungsversorgungseinheit 7 bereitgestellt werden. Dabei wird zunächst die axiale Position des virtuellen Pivotpunktes wiederum "grob" durch die Länge, den Abstand und die Polung der ersten Ablenkplatten 11a, 11b und der zweiten Ablenkplatten 16a und 16b vorgegeben. Die Orientierung bzw. Auslenkung des Teilchenstrahls 2 wird dann durch das mittels der ersten Spannungsversorgungseinheit 6 und der zweiten Spannungsversorgungseinheit 7 einstellbare Verhältnis der Amplituden der Auslenkungen beider Ablenkelemente - wie oben genannt - derart eingestellt, dass der virtuelle Pivotpunkt auf der Strahlachse 8 (also die axiale Position) in der virtuellen konjugierten Ebene KE liegt (bei dem dargestellten Ausführungsbeispiel liegt diese am Ort der Strahlquelle 1). Eine Feineinstellung kann mittels der beiden Magnetfelder $B_+$ und B. erfolgen. Es wird nochmals ausdrücklich klargestellt, dass bei dem illustrativen Beispiel gemäß Figur 5 ein Justieren der axialen Position des virtuellen Pivotpunktes durch die Brechkraft $B_+$ und $B_-$ nicht zwingend notwendig ist, da eine Einstellung des Pivotpunktes auch durch eine geeignete Wahl des Verhältnisses der beiden Spannungen $V_1$ und $V_2$ erfolgen kann.

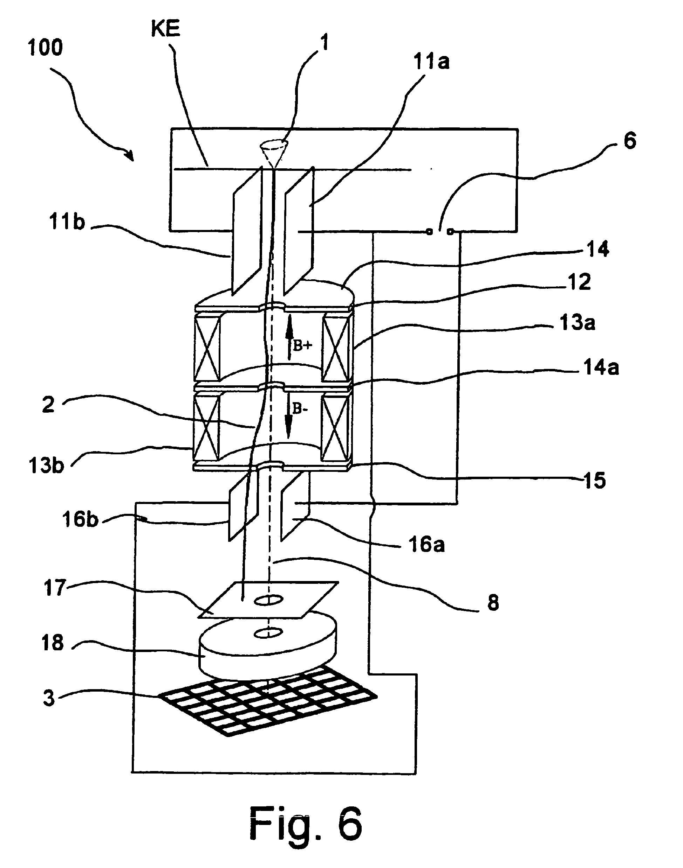

Figur 6 stellt ein erfindungsgemäßes Ausführungsbeispiel dar, wobei gleiche Bauteile wiederum mit gleichen Bezugszeichen versehen sind. Jedoch ist bei dem in Figur 6 dargestellten Ausführungsbeispiel erfindungsgemäß nur eine einzelne Spannungsversorgungseinheit, nämlich die Spannungsversorgungseinheit 6 vorgesehen, um das erste und das zweite Ablenkplattenpaar 11a, 11b und 16a, 16b mit Spannung zu versorgen. Im Unterschied zu dem illustrativen Beispiel gemäß Figur 5 erfolgt eine Einstellung des virtuellen Pivotpunktes bei dem Ausführungsbeispiel gemäß Figur 6 dadurch, dass $B_+$ und $B_-$ geeignet gewählt werden. Eine Einstellung des Verhältnisses der Spannungen erfolgt nicht. Die bereits weiter oben genannten Vorteile werden mit diesem Ausführungsbeispiel ebenfalls erzielt.

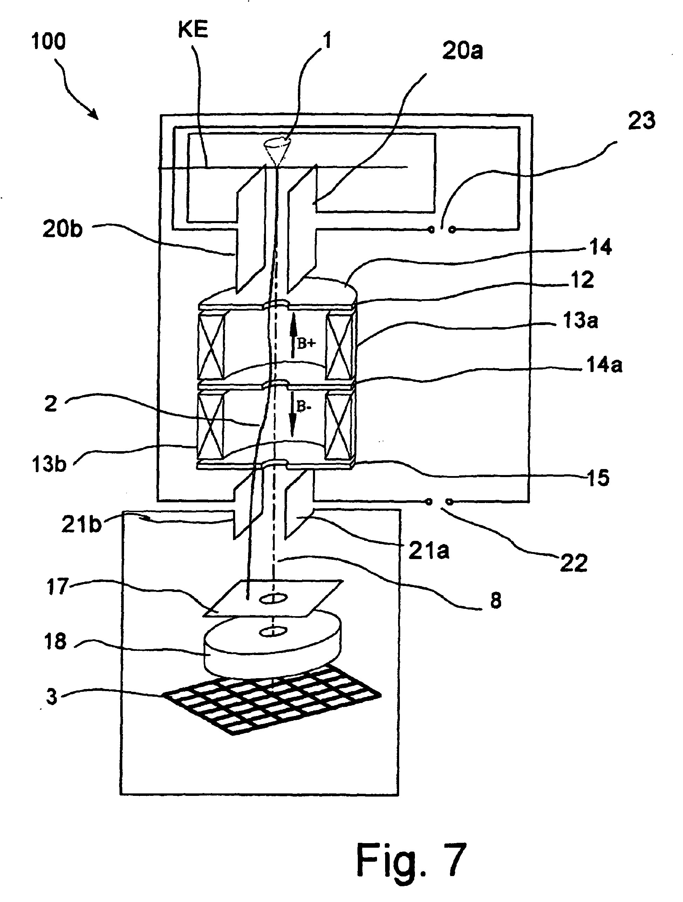

Ein weiteres zu dem illustrativen Beispiel gemäß Figur 5 sehr verwandtes illustrativen Beispiel ist in Figur 7 dargestellt, wobei gleiche Bezugszeichen gleiche Bauteile bezeichnen. Das in Figur 7 dargestellte illustrativen Beispiel unterscheidet sich von dem in Figur 5 dargestellten illustrativen Beispiel nur dahingehend, dass statt Ablenkplatten erste Spulenelemente 20a, 20b und zweite Spulenelemente 21a, 21 b zur Erzeugung eines auslenkenden Magnetfeldes verwendet werden, die durch entsprechende erste und zweite Versorgungseinheiten 22 und 23 versorgt werden.

Die in den Figuren 3 und 6 dargestellten Ausfuhrungsbeispiele und die in den Figuren 2, 4, 5, und 7 dargestellten illustrativen Beispiel gewährleisten, dass man das virtuelle Zentrum der Auslenkung (virtueller Pivotpunkt) des Teilchenstrahls 2 mit der virtuellen Position der konjugierten Ebene KE (also die virtuelle konjugierte Ebene) zur Deckung bringen kann. Dies läßt sich sowohl durch Ändern der Lage der virtuellen konjugierten Ebene (vergleiche Ausführungsbeispiel gemäß Figure 3 als auch durch Ändern der Lage des virtuellen Pivotpunktes (vergleiche Ausführungsbeispiel gemäß den Figuren 6) erreichen. Bei allen Ausführungsbeispielen ist von Vorteil, dass die gesamte Auslenkung des Teilchenstrahls 2 dabei derart erzielbar ist, dass hierdurch das oben beschriebene "Kippen eines Teilchenstrahls" am virtuellen Pivotpunkt ohne weiteres erreicht wird. Die Orientierung des Teilchenstrahls 2 wird durch das axiale Magnetfeld B bzw. $B_+$ und $B_-$ der magnetischen Einrichtung gewährleistet. Durch die vorgenannten Maßnahmen ist gewährleistet, dass der Teilchenstrahl 2 erfindungsgemäß auf die Austastblende 17 derart ausgelenkt wird, dass ein Auswandern des Teilchenstrahls 2 und somit ein unbeabsichtigtes Beaufschlagen des Objekts 3 mit dem Teilchenstrahl 2 vermieden wird. Im Grunde genommen wird hierdurch erzielt, dass der Teilchenstrahl 2 auf dem Objekt 3 stehen bleibt bzw. sich nur in einem Bereich bewegt (beispielsweise im Nanometerbereich), bei dem das Auswandern des Teilchenstrahls 2 vermieden wird.

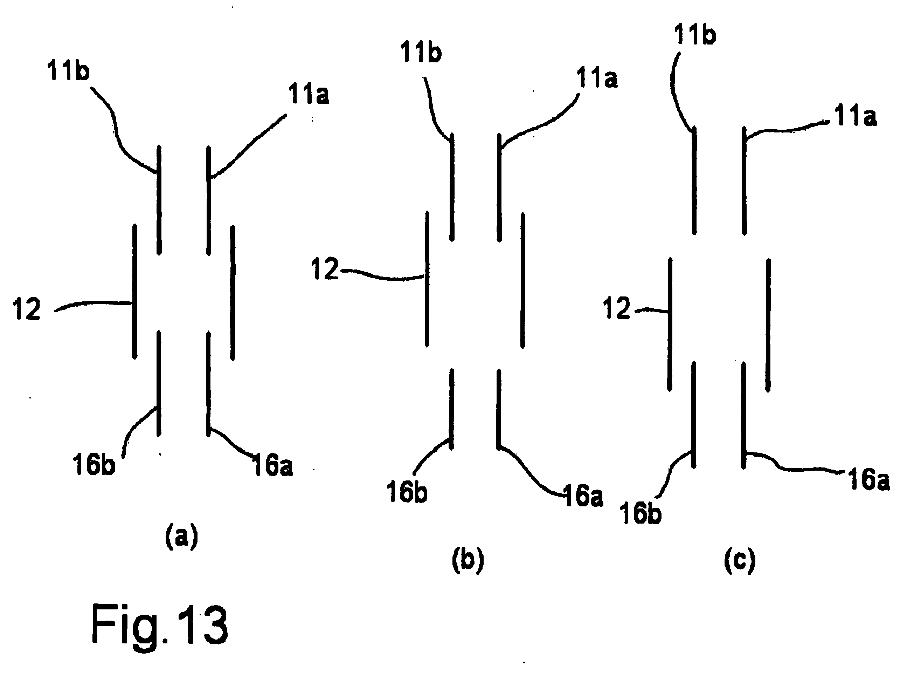

Figur 13 zeigt in einer schematischen Darstellung weitere Ausführungsbeispiele der Erfindung, die bestimmte Anordnungen des ersten Ablenkelements 11a, 11b, des zweiten Ablenkelements 16a, 16b und der magnetischen Einrichtung 12 beinhalten. So überlappen bei dem Ausführungsbeispiel gemäß Figur 13a das erste Ablenkelement 11 a, 11 b und das zweite Ablenkelement 16a, 16b teilweise mit der magnetischen Einrichtung 12. In anderen Worten ausgedrückt sind das erste Ablenkelement 11a, 11 b und das zweite Ablenkelement 16a, 16b in die magnetische Einrichtung 12 eingeschoben. Ähnliche Anordnungen zeigen die Figuren 13b und 13c. Bei diesen Anordnungen überlappt entweder nur das erste Ablenkelement 11a, 11b (Figur 13b) oder das zweite Ablenkelement 16a, 16b (Figur 13c) die magnetische Einrichtung 12. Die Ausführungsformen gemäß Figur 13 sind insbesondere dann von Vorteil, wenn als magnetische Einrichtung 12 eine bereits in einem Teilchenstrahlgerät existierende Linse verwendet wird. Sie gewährleisten eine gute Funktion der Erfindung auch bei geringem Bauraum.

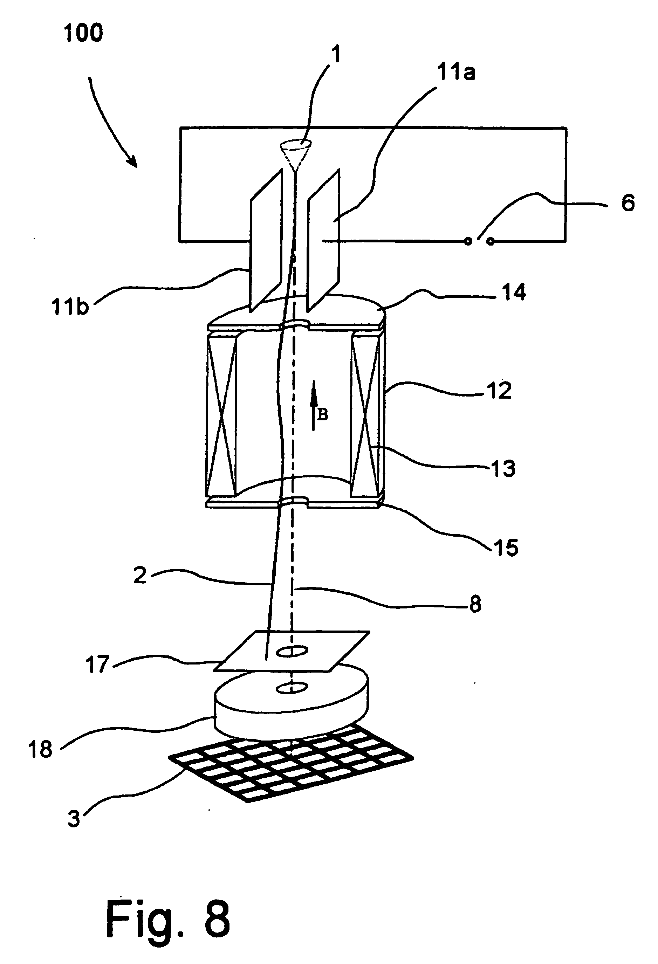

Ein weiteres Teilchenstrahlgerät das nicht Teil der Erfindung ist in Form eines Probenbearbeitungsgeräts 100 ist in der Figur 8 dargestellt. Gleiche Bauteile sind dabei wieder mit gleichen Bezugszeichen versehen. Das Teilchenstrahlgerät 100 gemäß der Figur 8 weist eine Strahlquelle 1 zur Erzeugung eines Teilchenstrahls 2 auf. Auch dieses Teilchenstrahlgerät 100 weist eine besondere Anordnung seiner Bauteile entlang einer Strahlachse 8 auf. Vom Strahlerzeuger 1 aus gesehen, sind entlang der Strahlachse 8 hinter dem Strahlerzeuger 1 zunächst ein erstes Ablenkelement 11 a, 11 b und anschließend eine magnetische Einrichtung 12 angeordnet. Das erste Ablenkelement weist zwei sich gegenüberliegende erste Ablenkplatten 11a und 11b auf, die ein Ablenkplattenpaar bilden. Die magnetische Einrichtung 12 weist Polschuhplatten 14 und 15 auf, zwischen denen ein Spulenelement 13 angeordnet ist.

Wiederum vom Strahlerzeuger 1 entlang der Strahlachse 8 aus gesehen sind hinter der magnetischen Einrichtung 12 eine Austastblende 17, eine Objektivlinse 18 sowie ein Objekt 3 angeordnet, welches in einer Objektebene angeordnet ist. Somit weist dieses illustrative Beispiel die folgende Anordnung gesehen von dem Strahlerzeuger 1 entlang der Strahlachse 8 auf: erstes Ablenkelement mit ersten Ablenkplatten 11 a, 11b - magnetische Einrichtung 12 - Austastblende 17 - Objektivlinse 18 - Objekt 3.

Die ersten Ablenkplatten 11a und 11 b werden von einer Spannungsversorgungseinheit 6 über Leitungen mit Spannung versorgt.

Das von der magnetischen Einrichtung 12 bereitgestellte Magnetfeld ist parallel zur Strahlachse 8 ausgerichtet (also axial zur Strahlachse 8, vergleiche auch obige Erläuterungen) und ist derart eingestellt, dass eine Larmordrehung von bis zu $\pm$ 90° erzielt wird. Das Magnetfeld B ist dabei derart ausgestaltet, dass es das erste Ablenkelement mit den ersten Ablenkplatten 11a und 11 b durchgreift. Bei einer alternativen Anordnung ist es vorgesehen, dass das erste Ablenkelement derart weit weg vom Magnetfeld B angeordnet ist, dass der Durchgriff vernachlässigbar ist oder gar nicht erfolgt.

Aufgrund des ersten Ablenkelements mit den beiden ersten Ablenkplatten 11a und 11b und des axial ausgerichteten Magnetfeldes B ist es ebenfalls möglich, dass keine ungewünschten Belichtungen des Objekts 3 während eines Austastens des Teilchenstrahls 2 vorkommen. Durch das erste Ablenkelement 11a, 11b und das Magnetfeld B wird der Teilchenstrahl 2 beim Austasten in eine Richtung gelenkt, in der eine zusätzliche Belichtung nicht stört. Aufgrund der Möglichkeit, das Ablenkelement 11a, 11b entsprechend beeinflussen zu können (beispielsweise durch Umpolung), reicht eine Larmordrehung des Magnetfeldes B von max. ± 90° aus, um während der Austastung jede mögliche Auslenkrichtung des Teilchenstrahls 2 einzustellen.

Vorzugsweise ist das bereitgestellte Magnetfeld B derart einstellbar, dass eine Larmordrehung von genau ± 45° erzielt wird. Dieses illustrative Beispiel gewährleistet bei entsprechend angesteuertem Ablenkelement 11 a, 11b, dass der Teilchenstrahl 2 in bestimmte Vorzugsrichtungen orientiert wird.

Die magnetische Einrichtung 12 ist bei diesem illustrative Beispiel als magnetische Rundlinse ausgebildet, die im Teilchenstrahlgerät 100 noch weitere Aufgaben wahrnimmt und somit nur eine zusätzliche Funktion erhält. Dabei ist die Geometrie und die Erregung der magnetischen Rundlinse derart gewählt, dass die gewünschte Larmordrehung (beispielsweise ±45°) bewirkt wird.

## Bezugszeichenliste

| 1 | Strahlquelle |
| 2 | Teilchenstrahl |
| 3 | Objekt |
| 4a, 4b | erstes Ablenkplattenpaar |
| 5a, 5b | zweites Ablenkplattenpaar |
| 6 | erste Spannungsversorgungseinheit |
| 7 | zweite Spannungsversorgungseinheit |
| 8 | Strahlachse |
| 9 | Austastblende |
| 10 | Kondensorlinse |
| 11a, 11b | erste Ablenkplatten |
| 12 | magnetische Einrichtung |
| 13 | Spulenelement |
| 13a, 13b | Spulenelemente |
| 14, 14a | Polschuhplatten |
| 15 | Polschuhplatte |
| 16a, 16b | zweite Ablenkplatten |
| 17 | Austastblende |
| 18 | Objektivlinse |
| 20a, 20b | erstes Spulenelement |
| 21a, 21b | zweites Spulenelement |
| 22 | erste Versorgungseinheit |
| 23 | zweite Versorgungseinheit |
| 100 | Teilchenstrahlgerät mit Ablenkvorrichtung |

## Patentansprüche

1.  Vorrichtung (100) zur Ablenkung eines Teilchenstrahls (2) aus einer Strahlachse (8) oder zur Einlenkung des Teilchenstrahls (2) In die Strahlachse (8), wobei

       - die Vorrichtung (100) mindestens ein erstes Ablenkelement (11a, 11b) aufweist,
       - vom ersten Ablankelement (11a, 11b) aus gesehen entlang der Strahlachse (8) mindestens eine magnetische Einrichtung (12) zur Bereitstellung eines Magnetfelds (B) und mindestens ein zweites Ablenkelement (16a, 16b) angeordnet sind,
       - das Magnetfeld (B) parallel zur Strahlachse (8) ausgerichtet ist, und wobei
       - die Vorrichtung (100) eine Spannungsversorgungseinheit (6) zur gemeinsamen Versorgung sowohl des ersten Ablenkelements (11a, 11b) als auch des zweiten Ablenkelements (16a, 16b) aufweist, wobei das erste Ablenkelement (11a, 11b) mit einer ersten Spannung (V1) versorgt ist, wobei das zweite Ablenkelement (16a, 16b) mit einer zweiten Spannung versorgt ist und wobei das Verhältnis der ersten Spannung zur zweiten Spannung mit 1 oder -1 vorgegeben ist,
**dadurch gekennzeichnet, dass**

- von dem ersten Ablenkelement (11a, 11b) aus gesehen hinter dem zweiten Ablenkelement (16a, 16b) mindestens eine Austasteinheit (17) angeordnet ist, und dass
- das Magnetfeld (B) von_der megnetischen Einrichtung (12) derart bereitgesteilt ist, dass der Teilchenstrahl (2) ohne ein Auswandern des Teilchenstrahls (2) in einer Oblektebene auf die Austasteinheit (17) ausgelenkt wird.

2. Vorrichtung (100) nach Anspruch 1, wobei diese ferner eine Objektivlinse (18) aufweist, welche, vom zweiten Ablenkelement (16a, 16b) aus gesehen, hinter der Austasteinheit (17) angeordnet ist und welche den Teilchenstrahl (2) in der Oblektebene fokussiert.

3. Vorrichtung (100) nach Anspruch 1, wobei die Austasteinheit (17) als Blende ausgebildet ist.

4. Vorrichtung (100) nach einem der vorangehenden Ansprüche,

- wobei das erste Ablenkelement (11a, 11b) mindestens zwei erste Ablenkeinheiten aufweist, und/oder
- wobei das zweite Ablenkelement (16a, 16b) mindestens zwei zweite Ablenkeinheiten aufweist.

5. Vorrichtung (100) nach Anspruch 4, wobei

- die zwei ersten Ablenkeinheiten des ersten Ablenkelements (11a, 11b) und/oder die zwei zweiten Ablenkeinhelten des zweiten Ablenkelements (16a, 16b) eine Länge entlang der Strahlachse (8) im Bereich von 5mm bis 60mm, vorzugsweise im Bereich von 10mm bis 30mm aufweisen, und/oder wobei
- die zwei ersten Ablenkeinheiten des ersten Ablenkelements voneinander und/oder die zwei zweiten Ablenkeinheiten des zweiten Ablenkelments (16a, 16b) voneinander einen Abstand senkrecht zur Strahlachse (8) im Bereich von 1mm bis 10mm, vorzugsweise im Bereich von 2mm bis 5mm aufweisen.

6. Vorrichtung (100) nach einem der vorangehenden Ansprüche, wobei

- das erste Ablenkelement (11a, 11b) mindestens eine erste plattenförmige Ablenkeinheit aufweist und/oder das zweite Ablenkelement (16a, 16b) mindestens eine zweite plattenförmige Ablenkeinheit aufweist, und/oder wobei
- das erste Ablenkelement mindestens ein erstes magnetisches Element (20a, 20b) aufweist und/oder das zweite Ablenkelement mindestens ein zweiten magnetisches Element (21a, 21 b) aufweist.

7. Vorrichtung (100) nach einem der vorangehenden Ansprüche, wobei

- die magnetische Einrichtung (12) mindestens ein Spulenelement (13, 13a, 13b) aufweist, und/oder
- die magnetische Einrichtung (12) mindestens einen Polschuh (14, 14a, 15) aufweist, und/oder wobei
- die magnetische Einrichtung (12) als Rundlinse ausgebildet ist.

8. Vorrichtung (100) nach einem der vorangehenden Ansprüche, wobei

- die magnetische Einrichtung (12) mindestens einen ersten Bereich (13a) mit einem ersten Magnetfeld (B.) und mindestens einen zweiten Bereich (13b) mit einem zweiten Magnetfeld (B.) aufweist, wobei das erste Magnetfeld ($B_+$) entgegengesetzt zu dem zweiten Magnetfeld (B.) ausgerichtet ist, und wobei
- das erste Magnetfeld (B.) eine Feldstärke aufweist, die unterschiedlich zu einer Feldstärke des zweiten Magnetfelds (B.) ist.

9. Vorrichtung (100) nach einem dar vorangehenden Ansprüche, wobei das erste Ablenkelement (11a, 11b) und/oder das zweite Ablenkelement (16a, 16b) zumindest teilweise die magnetische Einrichtung (12) überlappt/überlappen.

10. Tellchenstrahlgerät (100) mit einer Vorrichtung (100) nach einem der vorangehenden Ansprüche.

11. Teilchenstrahlgerät (100) nach Anspruch 10, mit

- mindestens einer Telichenquelle (1) zur Erzeugung eines Teilchenstrahls (2),

- mindestens einer Objektivlinse (18), und mit
- mindestens einer Kondensorlinse (10).

12. Teilchenstrahlgerät (100) nach Anspruch 10 oder 11, wobei das Teilchenstrehlgerät (100) als Lithographiegerät ausgebildet ist.

13. Teilchenstrahigerät (100) nach einem der Ansprüche 10 bis 13, wobei

- das Teilchenstrahigerät (100) als Elektronenstrahlgerät ausgebildet ist, oder wobei
- das Teilchenstrahlgerät (100) als Ionenstrahlgerät ausgebildet ist.

**Claims**

1. Device (100) for deflecting a particle beam (2) away from a beam axis (8) or for guiding the particle beam (2) toward the beam axis (8),
   wherein

   - the device (100) has at least one first deflection element (11 a, 11 b),
   - as viewed from the first deflection element (11 a, 11 b), at least one magnetic unit (12) to provide a magnetic field (B) and at least one second deflection element (16a, 16b) are situated along the beam axis (8),
   - the magnetic field (B) is oriented parallel to the beam axis (8), and wherein
   - the device (100) has a voltage supply unit (6) for jointly powering both the first deflection element (11a, 11 b) and the second deflection element (16a, 16b), wherein the first deflection element (11a, 11b) is powered with a first voltage ($V_1$), wherein the second deflection element (16a, 16b) is powered with a second voltage, and wherein the ratio of the first voltage to the second voltage is predefined as being 1 or -1,

   **characterized in that**

   - as viewed from the first deflection element (11 a, 11 b), at least one blanking unit (17) is situated behind the second deflection element (16a, 16b), and that
   - the magnetic field (B) is provided by the magnetic unit (12) such that the particle beam (2) is deflected to the blanking unit (17) without any drift of the particle beam (2) in an object plane .

2. Device (100) according to claim 1, further comprising an objective lens (18) which, as viewed from the second deflection element (16a, 16b), is situated behind the blanking unit (17) and which focuses the particle beam (2) in the object plane.

3. Device (100) according to claim 1, wherein the blanking unit (17) is designed as an aperture.

4. Device (100) according to one of the preceding claims,

   - wherein the first deflection element (11 a, 11 b) has at least two first deflection units, and/or
   - wherein the second deflection element (16a, 16b) has at least two second deflection units.

5. Device (100) according to claim 4, wherein

   - the two first deflection units of the first deflection element (11 a, 11 b) and/or the two second deflection units of the second deflection element (16a, 16b) have a length along the beam axis (8) in the range from 5 mm to 60 mm, preferably in the range from 10 mm to 30 mm, and/or wherein
   - the two first deflection units of the first deflection element and/or the two second deflection units of the second deflection element (16a, 16b) are separated by a distance perpendicular to the beam axis (8) in the range from 1 mm to 10 mm, preferably in the range from 2 mm to 5 mm.

6. Device (100) according to one of the preceding claims, wherein

   - the first deflection element (11a, 11 b) has at least one first plate-shaped deflection unit, and/or the second deflection element (16a, 16b) has at least one second plate-shaped deflection unit, and/or wherein

- the first deflection element has at least one first magnetic element (20a, 20b) and/or the second deflection element has at least one second magnetic element (21 a, 21 b).

7. Device (100) according to one of the preceding claims, wherein

- the magnetic unit (12) has at least one coil element (13, 13a, 13b), and/or
- the magnetic unit (12) has at least one pole shoe (14, 14a, 15), and/or wherein
- the magnetic unit (12) is designed as a round lens.

8. Device (100) according to one of the preceding claims, wherein

- the magnetic unit (12) has at least one first region (13a) having a first magnetic field ($B_+$) and at least one second region (13b) having a second magnetic field ($B_-$), the first magnetic field ($B_+$) being oriented opposite to the second magnetic field ($B_-$), and wherein
- the first magnetic field ($B_+$) has a field intensity which is different from a field intensity of the second magnetic field ($B_-$).

9. Device (100) according to one of the preceding claims, wherein the first deflection element (11 a, 11 b) and/or the second deflection element (16a, 16b) at least partially overlap the magnetic unit (12).

10. Particle beam apparatus (100) having a device (100) according to one of the preceding claims.

11. Particle beam apparatus (100) according to claim 10, having

- at least one particle source (1) for generating a particle beam (2),
- at least one objective lens (18), and having
- at least one condenser lens (10).

12. Particle beam apparatus (100) according to claim 10 or 11, wherein the particle beam apparatus (100) is designed as a lithography device.

13. Particle beam apparatus (100) according to one of claims 10 to 12, wherein

- the particle beam apparatus (100) is designed as an electron beam apparatus, or wherein
- the particle beam apparatus (100) is designed as an ion beam apparatus.

**Revendications**

1. Dispositif (100) de déviation d'un faisceau de particules (2) d'un axe de faisceau (8) ou d'alignement du faisceau de particules (2) dans l'axe de faisceau (8),

- le dispositif (100) comprenant au moins un premier élément de déviation (11 a, 11 b),
- au moins un système magnétique (12) pour la production d'un champ magnétique (B) et au moins un deuxième élément de déviation (16a, 16b) étant disposés, vus du premier élément de déviation (11a, 11b), le long de l'axe de faisceau (8),
- le champ magnétique (B) étant parallèle à l'axe de faisceau (8) et
- le dispositif (100) comprenant une unité d'alimentation en tension (6) pour l'alimentation commune aussi bien du premier élément de déviation (11 a, 11 b) que du deuxième élément de déviation (16a, 16b), le premier élément de déviation (11a, 11 b) étant alimenté par une première tension (V1), le deuxième élément de déviation (16a, 16b) étant alimenté par une deuxième tension et le rapport entre la première tension et la deuxième tension étant prédéfini par 1 ou -1,
**caractérisé en ce que**
- au moins une unité de suppression (17) est disposée, vue du premier élément de déviation (11a, 11b), derrière le deuxième élément de déviation (16a, 16b) et **en ce que**
- le champ magnétique (B) est généré par le système magnétique (12) de telle sorte que le faisceau de particules (2) soit dévié sans dérive du faisceau de particules (2) dans un plan objet sur l'unité de suppression (17).

**2.** Dispositif (100) selon la revendication 1, celui-ci comprenant en outre une lentille d'objectif (18) qui, vue du deuxième élément de déviation (16a, 16b), est disposée derrière l'unité de suppression (17) et qui focalise le faisceau de particules (2) dans le plan objet.

**3.** Dispositif (100) selon la revendication 1, l'unité de suppression (17) étant conçue comme un diaphragme.

**4.** Dispositif (100) selon l'une des revendications précédentes, dans lequel

- le premier élément de déviation (11a, 11b) comprend au moins deux premières unités de déviation et/ou dans lequel
- le deuxième élément de déviation (16a, 16b) comprend au moins deux deuxièmes unités de déviation.

**5.** Dispositif (100) selon la revendication 4, dans lequel

- les deux premières unités de déviation du premier élément de déviation (11a, 11 b) et/ou les deux deuxièmes unités de déviation du deuxième élément de déviation (16a, 16b) présentent une longueur le long de l'axe de faisceau (8) de l'ordre de 5 mm à 60 mm, de préférence de l'ordre de 10 mm à 30 mm et/ou dans lequel
- les deux premières unités de déviation du premier élément de déviation présentent et/ou les deux deuxièmes unités de déviation du deuxième élément de déviation (16a, 16b) présentent, entre elles, une distance perpendiculaire à l'axe de faisceau (8) de l'ordre de 1 mm à 10 mm, de préférence de l'ordre de 2 mm à 5 mm.

**6.** Dispositif (100) selon l'une des revendications précédentes, dans lequel

- le premier élément de déviation (11a, 11b) présente au moins une première unité de déviation en forme de plaque et/ou le deuxième élément de déviation (16a, 16b) présente au moins une deuxième unité de déviation en forme de plaque et/ou dans lequel
- le premier élément de déviation présente au moins un premier élément magnétique (20a, 20b) et/ou le deuxième élément de déviation présente au moins un deuxième élément magnétique (21 a, 21 b).

**7.** Dispositif (100) selon l'une des revendications précédentes, dans lequel

- le système magnétique (12) comprend au moins un élément de bobine (13, 13a, 13b) et/ou
- le système magnétique (12) comprend au moins une masse polaire (14, 14a, 15) et/ou
- le système magnétique (12) se présente sous la forme d'une lentille ronde.

**8.** Dispositif (100) selon l'une des revendications précédentes, dans lequel

- le système magnétique (12) comprend au moins une première zone (13a) avec un premier champ magnétique (B+) et au moins une deuxième zone (13b) avec un deuxième champ magnétique (B-), le premier champ magnétique (B+) étant opposé au deuxième champ magnétique (B-) et dans lequel
- le premier champ magnétique (B+) présente une intensité différente d'une intensité du deuxième champ magnétique (B-).

**9.** Dispositif (100) selon l'une des revendications précédentes, dans lequel le premier élément de déviation (11 a, 11 b) et/ou le deuxième élément de déviation (16a, 16b) se superpose au moins partiellement avec le système magnétique (12).

**10.** Appareil à faisceau de particules (100) avec un dispositif (100) selon l'une des revendications précédentes.

**11.** Appareil à faisceau de particules (100) selon la revendication 10, avec

- au moins une source de particules (1) pour la production d'un faisceau de particules (2),
- au moins une lentille d'objectif (18) et avec
- au moins une lentille de condensation (10).

**12.** Appareil à faisceau de particules (100) selon la revendication 10 ou 11, dans lequel l'appareil à faisceau de particules (100) est conçu comme un appareil de lithographie.

**13.** Appareil à faisceau de particules (100) selon l'une des revendications 10 à 12, dans lequel

- l'appareil à faisceau de particules (100) est conçu comme un appareil à faisceau d'électrons ou dans lequel
- l'appareil à faisceau de particules (100) est conçu comme un appareil à faisceau d'ions.

Fig. 1 (Stand der Technik)

Fig. 2

## Fig. 3

**Fig. 4**

**Fig. 5**

# Fig. 6

**Fig. 7**

Fig. 8

Fig. 9

Axiales Magnetfeld in Richtung der optischen Achse

*z entlang der optischen Achse in mm*

EP 2 195 821 B1

# Fig. 10

Axiales Magnetfeld in Richtung der optischen Achse

B+

B−

11a, 11b

14

14a

16a, 16b

15

Axiales Magnetfeld B(z) in mT

z entlang der optischen Achse in mm

KE

1

10

2

11b

11a

16b

16a

8

17

18

3

Fig. 11

KE

1

10

2

11b

11a

16b

16a

17

Fig. 12

18

3

11b    11a

12

16b    16a

(a)

11b    11a

12

16b    16a

(b)

11b    11a

12

16b    16a

(c)

Fig. 13

EP 2 195 821 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4434371 A
- US 5721432 A
- GB 2338070 A

**In der Beschreibung aufgeführte Nicht-Patentliteratur**

- **HERRN DR. MARTIN MÜLLER.** Abstimmbare Halbleiterlaser und schmalbandige Laserarrays mit verteilter lateraler Rückkopplung. *Würzburg,* 2003, 30-31